# EUROPEAN PATENT APPLICATION

(11) **EP 4 766 075 A1**
(43) Date of publication of application: **24.06.2026**
(21) Application number: 25219544.1
(22) Date of filing: 28.11.2025
(51) Int. Cl.: H10D 30/00, H10D 30/01

(54) **LINED CAVITY SPACER FOR GATE-ALL-AROUND TRANSISTOR**

(30) Priority: 17.12.2024 US 202418983864
(71) Applicant: INTEL Corporation, Santa Clara, CA 95054 (US)
(72) Inventor: CHAO, Robin, Portland, OR 97209 (US); YEUNG, Chun Wing, Portland, OR 97229 (US); CHU, Tao, Portland, OR 97229 (US); GHANI, Tahir, Portland, OR 97229 (US); HUNG, Ting-Hsiang, Santa Clara, CA 95051 (US); LIN, Chung-Hsun, Portland, OR 97229 (US); LIN, Chia-Ching, Portland, OR 97229 (US); XU, Guowei, Portland, OR 97229 (US); ZHANG, Kan, Hillsboro, OR 97123 (US); ZHANG, Feng, Portland, OR 97229 (US); ZHANG, Yang, Rio Rancho, NM 87124 (US)
(74) Representative: Samson & Partner Patentanwälte mbB

(57) **Abstract**

Described herein are nanoribbon transistors with lined cavity spacers deposited near the ends of the nanoribbons, including between the ends of adjacent nanoribbons. The cavity spacers include a liner layer next to the gate stack, and a fill material nested within the liner layer and adjacent to the source or drain. The liner layer is a non-oxide dielectric. For example, the liner may be a low-k nitride. The liner layer may be conformally deposited, and a portion of the liner layer may extend between the gate stack and the source or drain. Using a non-oxide material prevents removal of the liner during an oxide clean step prior to nanoribbon release.

## Description

### Background

Non-planar transistors are three-dimensional electronic devices that deviate from a traditional flat transistor design. Compared to planar transistors, non-planar transistors can provide improved control over current flow, reduced leakage, and enhanced performance, making it a key technology for smaller, faster, and more energy-efficient electronic devices. Examples of non-planar transistors include fin-shaped field-effect transistors, referred to as FinFETs, and gate-all-around (GAA) transistors. GAA transistors, also referred to as surrounding-gate transistors, have a gate material that surrounds a channel region on all sides. GAA transistors may be nanoribbon-based or nanowire-based.

In a nanoribbon transistor, a gate stack that may include one or more gate electrode materials and a gate dielectric may be provided around a portion of an elongated semiconductor structure called "nanoribbon", forming the gate stack on all sides of the nanoribbon. A source region and a drain region are provided on the opposite ends of the nanoribbon(s) and on either side of the gate stack, forming, respectively, a source and a drain of the nanoribbon transistor. The source and drain regions are insulated from the gate stack, so that the voltages at the three terminals (gate, source, and drain) may be separately controlled.

### Brief Description of the Drawings

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
FIG. 1A is a cross-section across a nanoribbon-based transistor showing the source, gate, and drain, according to some embodiments of the present disclosure.
FIG. 1B is a cross-section of the nanoribbon-based transistor through the plane AA' in FIG. 1A, according to some embodiments of the present disclosure.
FIG. 2 is a flow diagram of a process for fabricating lined cavity spacers in a nanoribbon-based transistor, according to some embodiments of the present disclosure.
FIG. 3 is a cross-section of layers of alternating materials for forming nanoribbons, according to some embodiments of the present disclosure.
FIG. 4 is a cross-section illustrating dummy gate regions over the layers of FIG. 3, according to some embodiments of the present disclosure.
FIG. 5 is a cross-section illustrating regions etched for forming sources and drains, according to some embodiments of the present disclosure.
FIG. 6 is a cross-section illustrating the formation of cavities between adjacent nanoribbons, according to some embodiments of the present disclosure.
FIG. 7A is a cross-section illustrating deposition of a spacer liner material in the cavities, according to some embodiments of the present disclosure.
FIG. 7B is an enlarged view of a portion of FIG. 7A, according to some embodiments of the present disclosure.
FIG. 8A is a cross-section illustrating deposition of a spacer fill material over the spacer liner material, according to some embodiments of the present disclosure.
FIG. 8B is an enlarged view of a portion of FIG. 8A, according to some embodiments of the present disclosure.
FIG. 9 is a cross-section illustrating removal of the spacer fill material from areas outside of the cavities, according to some embodiments of the present disclosure.
FIG. 10A is a cross-section illustrating removal of the spacer liner material from areas outside of the cavities, according to some embodiments of the present disclosure.
FIG. 10B is an enlarged view of a portion of FIG. 10A, according to some embodiments of the present disclosure.
FIG. 11 is a cross-section illustrating growth of the sources and drains, according to some embodiments of the present disclosure.
FIG. 12A is a cross-section illustrating formation of the gate stack, according to some embodiments of the present disclosure.
FIG. 12B is an enlarged view of a portion of FIG. 12A, illustrating the lined cavity spacers in greater detail, according to some embodiments of the present disclosure.
FIG. 13 is a cross-section illustrating lined cavity spacers adjacent to a gate stack with a gate dielectric, according to some embodiments of the present disclosure.
FIGS. 14A and 14B are top views of a wafer and dies that include one or more nanoribbon transistors with lined cavity spacers accordance with any of the embodiments disclosed herein.
FIG. 15 is a cross-sectional side view of an IC device that may include one or more nanoribbon transistors with lined cavity spacers in accordance with any of the embodiments disclosed herein.
FIG. 16 is a cross-sectional side view of an IC device assembly that may include nanoribbon transistors with lined cavity spacers in accordance with any of the embodiments disclosed herein.
FIG. 17 is a block diagram of an example computing device that may include one or more nanoribbon transistors with lined cavity spacers in accordance with any of the embodiments disclosed herein.

### Detailed Description

The systems, methods and devices of this disclosure each have several innovative aspects, no single one of which is solely responsible for all desirable attributes disclosed herein. Details of one or more implementations of the subject matter described in this specification are set forth in the description below and the accompanying drawings.

Described herein are integrated circuit (IC) devices that include non-planar transistors, such as nanoribbon-based transistors, having lined cavity spacers between adjacent nanoribbons in a stack of nanoribbons. Non-planar transistors provide several advantages over planar transistor architectures. For example, non-planar transistors provide improved electrostatic transistor control and faster transistor speeds relative to other transistor architectures. For certain applications, nanoribbon-based channels are particularly advantageous, providing increased drive current at smaller scales relative to other non-planar architectures.

Transistors typically include a gate stack coupled to a semiconductor channel, which may be a nanoribbon or a stack of nanoribbons. A gate stack often includes a gate electrode and a gate dielectric, with the gate dielectric formed between the gate electrode and the channel material. In a nanoribbon transistor, the gate dielectric is formed around each nanoribbon, and the gate electrode is formed over and around the gate dielectric, including in spaces between adjacent nanoribbons in the stack. In some implementations of nanoribbon transistors, the gate dielectric is omitted. A source region is formed at one end of the nanoribbons, and a drain region is formed at the opposite end of the nanoribbons, thus realizing a three-terminal device.

Cavity spacers, also referred to as "dimple spacers" or "inner spacers," provide electrical isolation between the source and drain regions (referred to herein as S/D regions) formed at the ends of the nanoribbons and conductive gate material deposited between adjacent nanoribbons. Previous cavity spacers included an oxide-based dielectric material. For example, a cavity spacer may include an oxide liner followed by a low-k cavity fill material. When an oxide liner is used, at least a portion of the liner may be removed during the nanowire release process. For example, if nanowires are formed from a stack of silicon and silicon germanium (SiGe), an oxide removal process, also referred to as an oxide clean, may be performed prior to removing the SiGe to remove any oxygen that has formed on the silicon and SiGe stack. This oxide removal process can remove an oxide-based spacer material, and in some cases, may remove a greater amount of the spacer liner than intended or desired.

A gate stack is formed after the nanowire release and oxide removal steps. As noted above, the cavity spacer is meant to isolate the gate electrode on one side of the cavity spacer from the S/D regions on the other side of the cavity spacer. In some cases, if the oxide cavity material (e.g., the oxide liner) is etched back to the area where the S/D region is deposited, a short may form between the gate electrode and the S/D region. The oxide removal may provide a path through the cavity spacer and to the S/D region, and the gate electrode material may fill in this path, creating a short.

Lined cavity spacers are provided herein that include a first layer or liner with a non-oxide material, and a fill material deposited after the liner. The first dielectric material is a dielectric material that does not include oxygen and is selective to an oxide etch. For example, the first dielectric material may include nitrogen. The first dielectric material forms a cavity spacer liner adjacent to where the gate stack is formed. The first dielectric material may have a relatively low dielectric constant (e.g., a low-k material having a dielectric constant less than that of silicon dioxide). The second dielectric material may be another low-k material, e.g., another low-k nitride. In some embodiments, the second dielectric material may include oxygen, e.g., silicon dioxide or another suitable dielectric material. The liner may protect the spacer during later processing, e.g., during nanoribbon release and formation of the gate stack. Furthermore, the liner itself is not removed by the oxide cleaning process.

The first dielectric material may be a relatively thin liner in the cavity spacer, e.g., having a width of 2 nanometers (nm) or less. In some cases, the cavity spacer liner may be even thinner, e.g., having a width of 1 nm or less, 0.8 nm or less, or 0.5 nm or less. The cavity spacer liner may be conformally deposited prior to depositing the cavity fill material. The cavity spacer liner may extend along a sidewall of the gate stack, between the gate stack and the spacer fill. Other portion(s) of the cavity spacer liner may also extend along nanoribbons above and/or below the spacer fill. Said another way, the cavity spacer fill may be nested within the cavity spacer liner. The arrangement of the cavity spacer liner and the cavity spacer fill is illustrated in the figures, discussed below.

The nanoribbon transistors described herein may be implemented in one or more components associated with an IC. In various embodiments, components associated with an IC include, for example, transistors, diodes, power sources, resistors, capacitors, inductors, sensors, transceivers, receivers, antennas, etc. Components associated with an IC may include those that are mounted on an IC or those connected to an IC. The IC may be either analog or digital and may be used in a number of applications, such as microprocessors, optoelectronics, logic blocks, audio amplifiers, etc., depending on the components associated with the IC. The IC may be employed as part of a chipset for executing one or more related functions in a computer.

For purposes of explanation, specific numbers, materials and configurations are set forth in order to provide a thorough understanding of the illustrative implementations. However, it will be apparent to one skilled in the art that the present disclosure may be practiced without the specific details or/and that the present disclosure may be practiced with only some of the described aspects. In other instances, well known features are omitted or simplified in order not to obscure the illustrative implementations.

In the following detailed description, reference is made to the accompanying drawings that form a part hereof, and in which is shown, by way of illustration, embodiments that may be practiced. It is to be understood that other embodiments may be utilized and structural or logical changes may be made without departing from the scope of the present disclosure. Therefore, the following detailed description is not to be taken in a limiting sense.

Various operations may be described as multiple discrete actions or operations in turn, in a manner that is most helpful in understanding the claimed subject matter. However, the order of description should not be construed as to imply that these operations are necessarily order dependent. In particular, these operations may not be performed in the order of presentation. Operations described may be performed in a different order from the described embodiment. Various additional operations may be performed, and/or described operations may be omitted in additional embodiments.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). The term "between," when used with reference to measurement ranges, is inclusive of the ends of the measurement ranges. The meaning of "a," "an," and "the" include plural references. The meaning of "in" includes "in" and "on."

The description uses the phrases "in an embodiment" or "in embodiments," which may each refer to one or more of the same or different embodiments. Furthermore, the terms "comprising," "including," "having," and the like, as used with respect to embodiments of the present disclosure, are synonymous. The disclosure may use perspective-based descriptions such as "above," "below," "top," "bottom," and "side"; such descriptions are used to facilitate the discussion and are not intended to restrict the application of disclosed embodiments. The accompanying drawings are not necessarily drawn to scale. The terms "substantially," "close," "approximately," "near," and "about," generally refer to being within +/- 20% of a target value, unless specified otherwise. Unless otherwise specified, the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

In the following detailed description, various aspects of the illustrative implementations will be described using terms commonly employed by those skilled in the art to convey the substance of their work to others skilled in the art. For example, as used herein, a "logic state" of a ferroelectric memory cell refers to one of a finite number of states that the cell can have, e.g. logic states "1" and "0," each state represented by a different polarization of the ferroelectric material of the cell. In another example, as used herein, a "READ" and "WRITE" memory access or operations refer to, respectively, determining/sensing a logic state of a memory cell and programming/setting a logic state of a memory cell. In other examples, the term "connected" means a direct electrical or magnetic connection between the things that are connected, without any intermediary devices, while the term "coupled" means either a direct electrical or magnetic connection between the things that are connected or an indirect connection through one or more passive or active intermediary devices. The term "circuit" means one or more passive and/or active components that are arranged to cooperate with one another to provide a desired function. In yet another example, a "high-k dielectric" refers to a material having a higher dielectric constant (k) than silicon oxide. The terms "oxide," "carbide," "nitride," etc. refer to compounds containing, respectively, oxygen, carbon, nitrogen, etc.

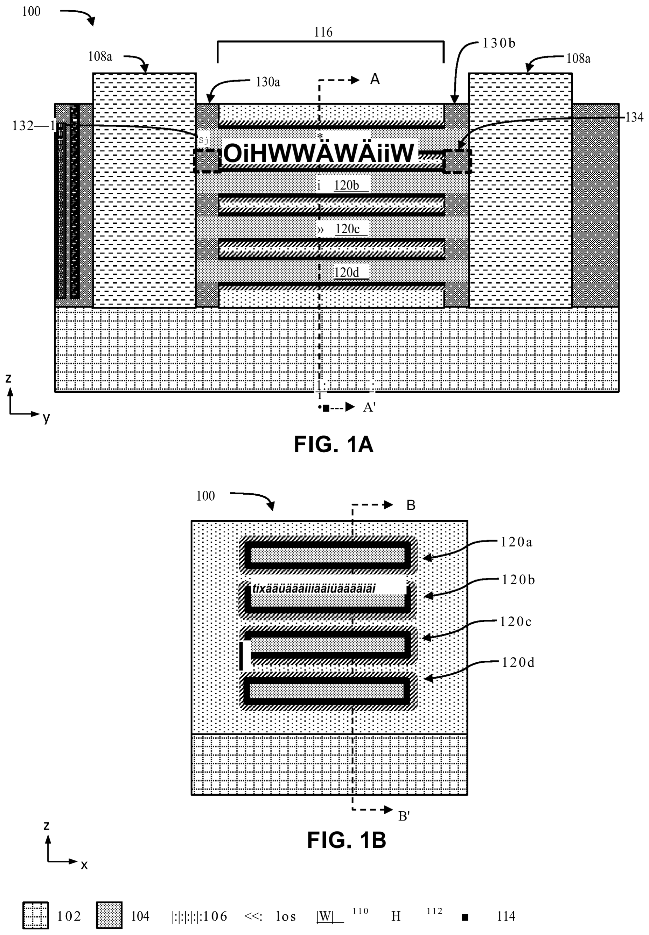

For convenience, if a collection of drawings designated with different letters are present, e.g., FIGS. 1A-1B, such a collection may be referred to herein without the letters, e.g., as "FIG. 1."

FIGs. 1A-1B illustrate an example architecture of a nanoribbon-based transistor. FIG. 1A is a cross-section across a transistor 100 showing the source, gate, and drain. FIG. 1B is a cross-section across the gate regions of the transistor 100. FIG. 1B is a cross-section through the plane AA' in FIG. 1A, and FIG. 1A is a cross-section through the plane BB' in FIG. 1B.

A number of elements referred to in the description of FIGs. 1A, 1B, 3-13 and with reference numerals are illustrated in these figures with different patterns, with a legend at the bottom of the page showing the correspondence between the reference numerals and patterns. The legend illustrates that FIGs. 1A and 1B use different patterns to show a support structure 102, a channel material 104, a dielectric material 106, a source or drain (S/D) contact 108, a gate electrode 110, an oxide 112, and a high-k dielectric 114.

In the drawings, some example structures of various devices and assemblies described herein are shown with precise right angles and straight lines, but it is to be understood that such schematic illustrations may not reflect real-life process limitations which may cause the features to not look so "ideal" when any of the structures described herein are examined using e.g., scanning electron microscopy (SEM) images or transmission electron microscope (TEM) images. In such images of real structures, possible processing defects could also be visible, e.g., not-perfectly straight edges of materials, tapered vias or other openings, inadvertent rounding of corners or variations in thicknesses of different material layers, occasional screw, edge, or combination dislocations within the crystalline region, and/or occasional dislocation defects of single atoms or clusters of atoms. There may be other defects not listed here but that are common within the field of device fabrication.

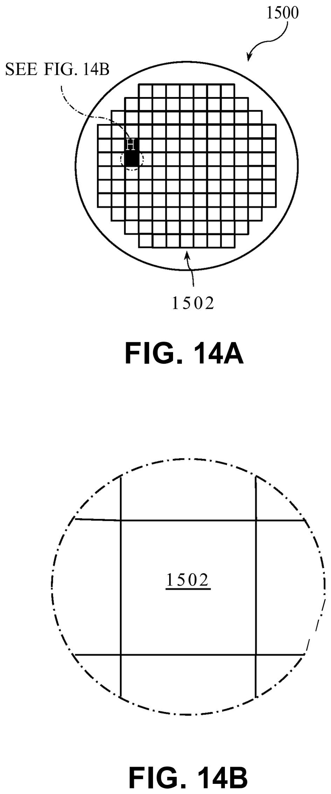

In general, implementations of the present disclosure may be formed or carried out on a support structure, e.g., the support structure 102 illustrated in FIG. 1. The support structure 102 may be, e.g., a substrate, a die, a wafer or a chip. For example, the support structure may be the wafer 1500 of FIG. 14A, discussed below, and may be, or be included in, a die, e.g., the singulated die 1502 of FIG. 14B, discussed below. The support structure 102 extends along the x-y plane in the coordinate system shown in FIG. 1.

In some embodiments, the support structure may be a substrate that includes silicon and/or hafnium. More generally, the support structure may be a semiconductor substrate composed of semiconductor material systems including, for example, N-type or P-type materials systems. In one implementation, the semiconductor substrate may be a crystalline substrate formed using a bulk silicon or a silicon-on-insulator (SOI) substructure. In other implementations, the semiconductor substrate may be formed using alternate materials, which may or may not be combined with silicon, that include, but are not limited to, germanium, silicon germanium, indium antimonide, lead telluride, indium arsenide, indium phosphide, gallium arsenide, aluminum gallium arsenide, aluminum arsenide, indium aluminum arsenide, aluminum indium antimonide, indium gallium arsenide, gallium nitride, indium gallium nitride, aluminum indium nitride or gallium antimonide, or other combinations of group III-V materials (i.e., materials from groups III and V of the periodic system of elements), group II-VI (i.e., materials from groups II and IV of the periodic system of elements), or group IV materials (i.e., materials from group IV of the periodic system of elements). In some embodiments, the substrate may be non-crystalline. In some embodiments, the support structure may be a printed circuit board (PCB) substrate. Although a few examples of materials from which the substrate may be formed are described here, any material that may serve as a foundation upon which a semiconductor device including one or more nanoribbon transistors, as described herein, may be built falls within the spirit and scope of the present disclosure.

In FIGs. 1A and 1B, a transistor 100 is formed over a support structure 102. The transistor 100 includes a channel material 104 formed into four nanoribbons stacked on top of each other. The channel material 104 may be a semiconductor, such as silicon or other semiconductor materials described herein.

The transistor 100 includes nanoribbons 120a, 120b, 120c, and 120d, referred to collectively as nanoribbons 120 or individually as a nanoribbon 120. Each nanoribbon 120 is at a different height in the z-direction in the orientation shown in FIGs. 1A and 1B, i.e., a different distance from the support structure 102, where the nanoribbon 120a is the greatest distance from the support structure 102, and the nanoribbon 120d is the smallest distance from the support structure 102. S/D contacts 108a and 108b are formed at either end of the nanoribbon channels 120, as illustrated in FIG. 1A.

The S/D contacts 108 may be formed from one or more layers of doped semiconductors, metals, metal alloys, or other materials. In some embodiments described herein, the S/D contacts 108 may include a doped semiconductor, such as silicon or another semiconductor doped with an N-type dopant or a P-type dopant. In some embodiments, the S/D contacts 108 may include multiple layers with different levels of conductivity, e.g., a doped semiconductor followed by a more highly doped semiconductor, or a semiconductor followed by metal.

A central portion of each of the nanoribbon channels 120 is surrounded by a gate stack 116, which in this example, includes a gate electrode 110 and gate dielectrics 112 and 114. Nanoribbon transistors often include a gate dielectric that surrounds the nanoribbon channels 120, and a gate electrode that surrounds the gate dielectric. In this example, the gate dielectric around each nanoribbon channel 120 includes a layer of an oxide 112 and a layer of a high-k dielectric 114. The oxide 112 is grown directly on the nanoribbon channels 120, and the high-k dielectric 114 surrounds the oxide 112. The oxide 112 may include oxygen in combination with the channel material 104. For example, if the nanoribbon channels are formed from silicon, the gate dielectric may include a layer of silicon oxide. The high-k dielectric 114 may be formed over the oxide 112. The gate electrode 110 surrounds the high-k dielectric 114. In this example, the gate electrode 110 is above and below the nanoribbon stack, and between adjacent nanoribbons 120.

The gate electrode 110 includes a conductive material, such as a metal. The gate electrode 110 may include at least one P-type work function metal or N-type work function metal, depending on whether the transistor 100 is a PMOS transistor or an NMOS transistor. For a PMOS transistor, metals that may be used for the gate electrode 110 may include, but are not limited to, ruthenium, palladium, platinum, cobalt, nickel, and conductive metal oxides (e.g., ruthenium oxide). For an NMOS transistor, metals that may be used for the gate electrode 110 include, but are not limited to, hafnium, zirconium, titanium, tantalum, aluminum, alloys of these metals, and carbides of these metals (e.g., hafnium carbide, zirconium carbide, titanium carbide, tantalum carbide, and aluminum carbide). In some embodiments, the gate electrode 110 may include a stack of two or more metal layers, where one or more metal layers are work function metal layers and at least one metal layer is a fill metal layer.

In various embodiments, the high-k gate dielectric 114 may include one or more high-k dielectric materials and may include elements such as hafnium, silicon, oxygen, titanium, tantalum, lanthanum, aluminum, zirconium, barium, strontium, yttrium, lead, scandium, niobium, and zinc. Examples of high-k materials that may be used include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, tantalum oxide, tantalum silicon oxide, lead scandium tantalum oxide, and lead zinc niobate. In some embodiments, one or both of the gate dielectrics 112 and 114 may have a thickness between about 0.5 nanometers and 3 nanometers, including all values and ranges therein, e.g., between about 1 and 3 nanometers, or between about 1 and 2 nanometers.

Regions of the transistor 100 outside of the nanoribbons 120, gate stack 116, and S/D contacts 108 are filled in with a dielectric material 106. In the region between the gate stack 116 and the S/D contacts 108, the dielectric material 106 forms a series of cavity spacers 130. In particular, a set of cavity spacers 130a (including the cavity spacer 132) are in the region between the S/D contact 108a and the gate stack 116, and a set of cavity spacers 130b (including the cavity spacer 134) are in the region between the S/D contact 108b and the gate stack 116. Some of the cavity spacers 130 are between adjacent nanoribbons. For example, the cavity spacer 132 is between the nanoribbon 120a and the nanoribbon 120b, and in particular, between two ends of the nanoribbons 120a and 120b. A portion of the gate stack 116 (in this case, going from top to bottom, a layer of oxide 112, a layer of high-k dielectric 114, a layer of gate electrode 110, a second layer of high-k dielectric 114, and a second layer of oxide 112) are on the right side of the cavity spacer 132, and the S/D contact 108a is on the left side of the cavity spacer 132, in the orientation shown. The cavity spacer 134 in the second set of cavity spacers 130b is on the opposite side of the transistor 100 from the cavity spacer 132. The cavity spacer 134 is between the opposite ends of the nanoribbons 120a and 120b from the cavity spacer 132, and the cavity spacer 134 is next to an opposite end of the gate stack 116 from the cavity spacer 132. Thus, the gate stack 116 (including the oxide 112, high-k dielectric 114, and gate electrode 110) is between the cavity spacers 132 and 134.

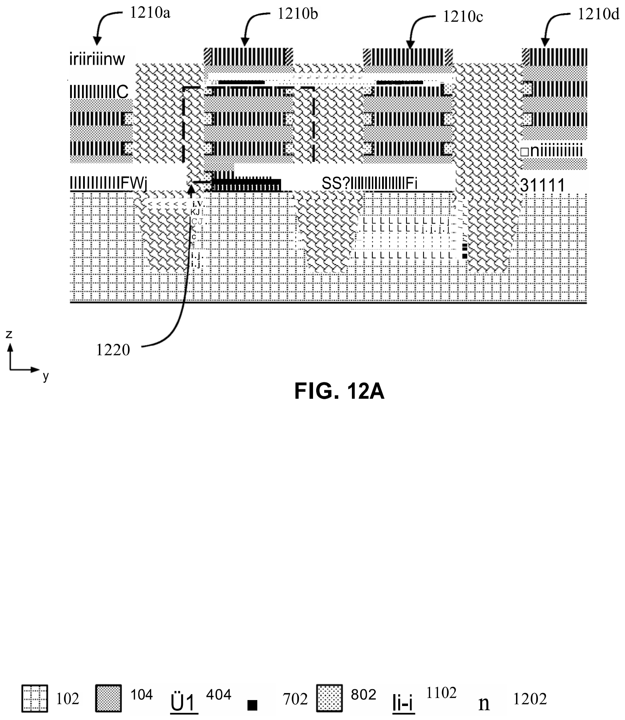

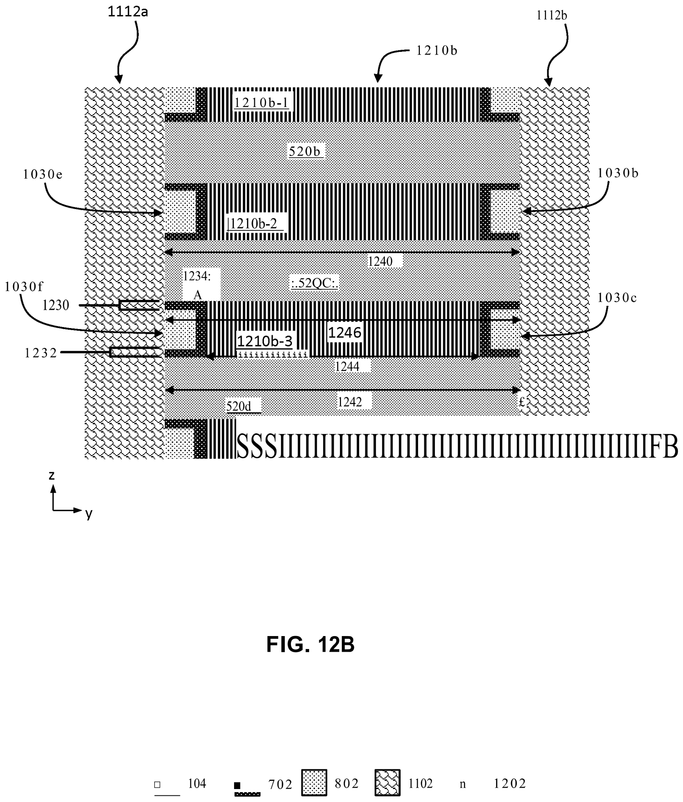

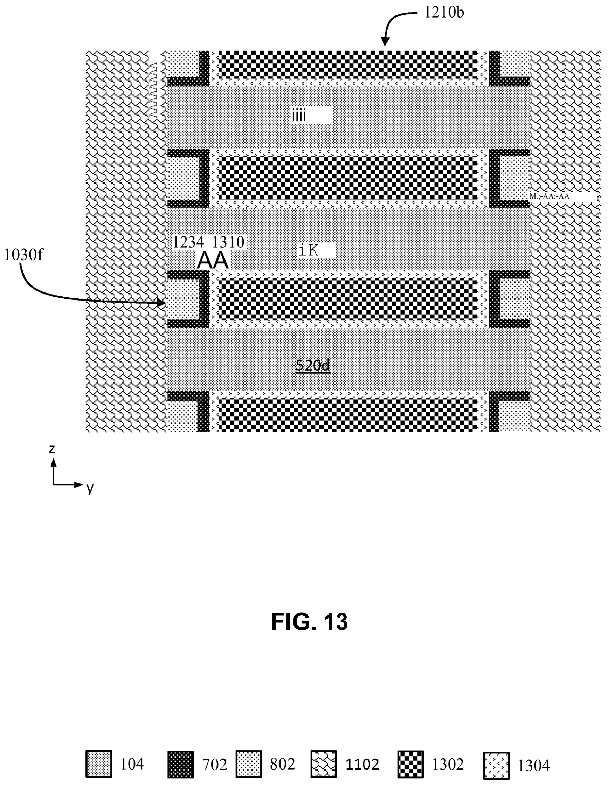

Each cavity spacer 130 (e.g., the cavity spacer 132 and the cavity spacer 134) may have a liner layer and a fill layer, thus forming a lined cavity spacer as described herein. The liner layer that is adjacent to the gate stack 116 may include a nitride or another non-oxide dielectric material. The fill layer that is adjacent to the S/D contact 108a or 108b may include the same dielectric material or a different dielectric material. FIGs. 12 and 13 illustrate examples of lined cavity spacers that may be included in the transistor 100 in the sets of cavity spacers 130a and 130b.

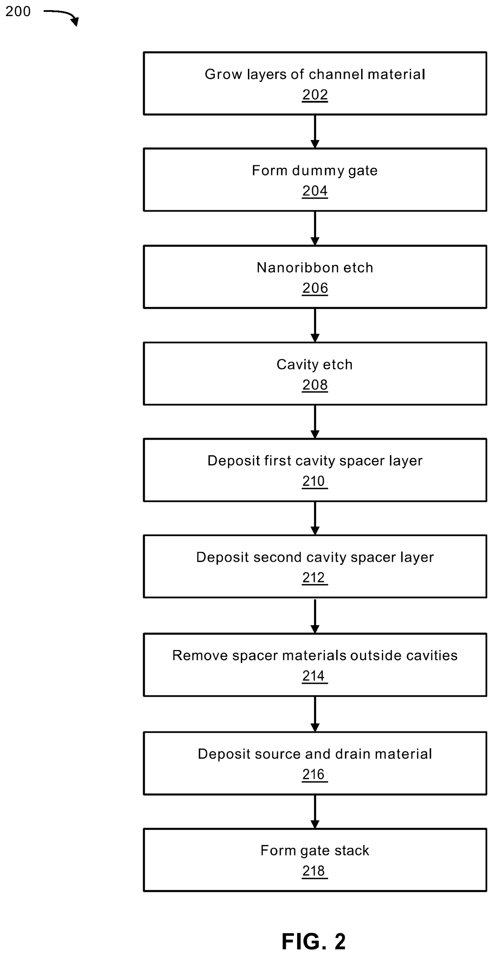

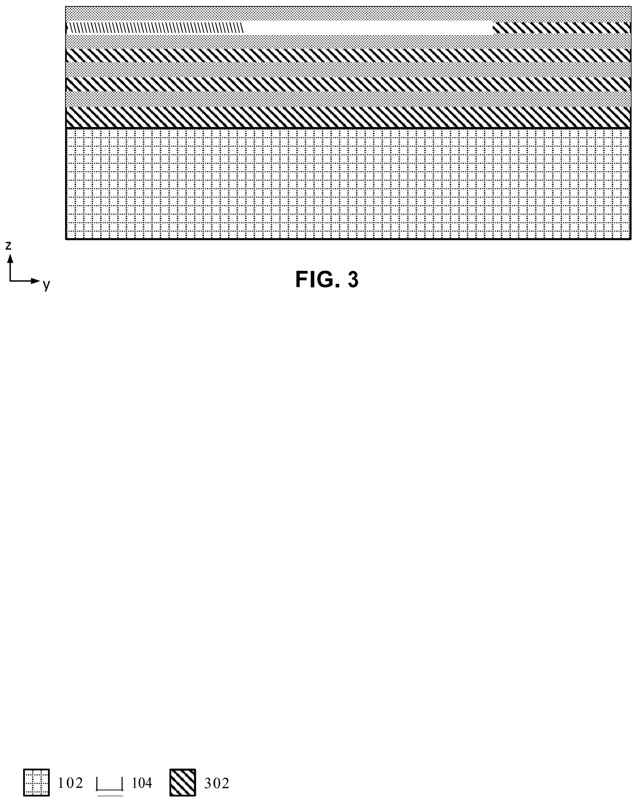

FIG. 2 is a flowchart illustrating an example processing method 200 for fabricating nanoribbon-based transistors with lined cavity spacers, according to some embodiments of the present disclosure. FIGs. 3-12 illustrate various steps in the processing method 200 of FIG. 2, according to some embodiments of the present disclosure. In general, the processing method 200 is performed across a wafer, with many individual transistors formed on the wafer. FIGs. 3-12 illustrate cross-sections of processing steps across several transistors. The processing method 200 describes a process of fabricating nanoribbon channels with lined cavity spacers. Additional steps may be performed before, during, and/or after the processing method 200 to produce a device that includes the lined cavity spacers described herein, e.g., to produce the nanoribbon transistor shown in FIG. 1, or to produce an IC device that includes nanoribbon transistors with lined cavity spacers.

At 202, a process for growing a channel material over a support structure is performed. To produce a stack of nanoribbons, the channel material may be grown in layers with a sacrificial material between layers of channel material. FIG. 3 is a cross-section illustrating layers of alternating materials 104 and 302 formed over a support structure 102, e.g., a substrate as described with respect to FIG. 1. The alternating materials 104 includes layers of the channel material 104 separated by layers of a sacrificial material 302. In this example, four layers of the channel material 104 are illustrated; in other examples, fewer or additional layers (e.g., two layers, three layers, five layers, six layers, or more) may be included.

In general, to form nanoribbon channels, alternating layers of the channel material 104 and the sacrificial material 302 are deposited over the support structure 102. The channel material 104 and sacrificial materials 302 include different materials. In one example, the channel material 104 is silicon, while the sacrificial material 302 includes silicon and germanium. The sacrificial material 302 may be chosen to have a similar crystal structure to the channel material 104, so that monocrystalline layers of the channel material 104 (or substantially monocrystalline layers, e.g., with a grain size of at least 5 nanometers, at least 20 nanometers, at least 50 nanometers, or at least 100 nanometers) and monocrystalline layers of the sacrificial material 302 (or substantially monocrystalline layers) may be formed over each other. In different embodiments, the channel material 104 and/or the sacrificial material 302 may be formed of any suitable single-crystal material, such as sapphire, quartz, silicon, a compound of silicon (e.g., silicon oxide), indium phosphide, germanium or a germanium alloy (e.g., silicon germanium), gallium, arsenic (e.g., an arsenide III compound, where arsenic III is in combination with another element such as boron, aluminum, gallium, or indium), or any group III-V material (i.e., materials from groups III and V of the periodic system of elements).

More generally, the channel material 104 may be composed of semiconductor material systems including, for example, N-type or P-type materials systems. In other embodiments, the channel material 104 may include a high mobility oxide semiconductor material, such as tin oxide, antimony oxide, indium oxide, indium tin oxide, titanium oxide, zinc oxide, indium zinc oxide, indium gallium zinc oxide (IGZO), gallium oxide, titanium oxynitride, ruthenium oxide, or tungsten oxide. The channel material 104 may include one or more of cobalt oxide, copper oxide, ruthenium oxide, nickel oxide, niobium oxide, copper peroxide, indium telluride, molybdenite, molybdenum diselenide, tungsten diselenide, tungsten disulfide, molybdenum disulfide, N- or P-type amorphous or polycrystalline silicon, monocrystalline silicon, germanium, indium arsenide, indium gallium arsenide, indium selenide, indium antimonide, zinc antimonide, antimony selenide, silicon germanium, gallium nitride, aluminum gallium nitride, indium phosphite, black phosphorus, zinc sulfide, indium sulfide, gallium sulfide, each of which may possibly be doped with one or more of gallium, indium, aluminum, fluorine, boron, phosphorus, arsenic, nitrogen, tantalum, tungsten, and magnesium, etc.

In some embodiments, multiple channel materials may be included within an IC device. For example, an IC device may include both N-type metal-oxide-semiconductor (NMOS) transistors and P-type MOS (PMOS) transistors, e.g., alternating rows of NMOS and PMOS transistors. NMOS and PMOS logic can use different groups of channel material 104, e.g., silicon may be used to form an N-type semiconductor channel, while silicon germanium may be used to form a P-type semiconductor channel. In some embodiments, a single channel material 104 is used (e.g., silicon), and different portions (e.g., channel material to form different transistors) may include different dopants, e.g., N-type dopants for NMOS transistors and P-type dopants for PMOS transistors.

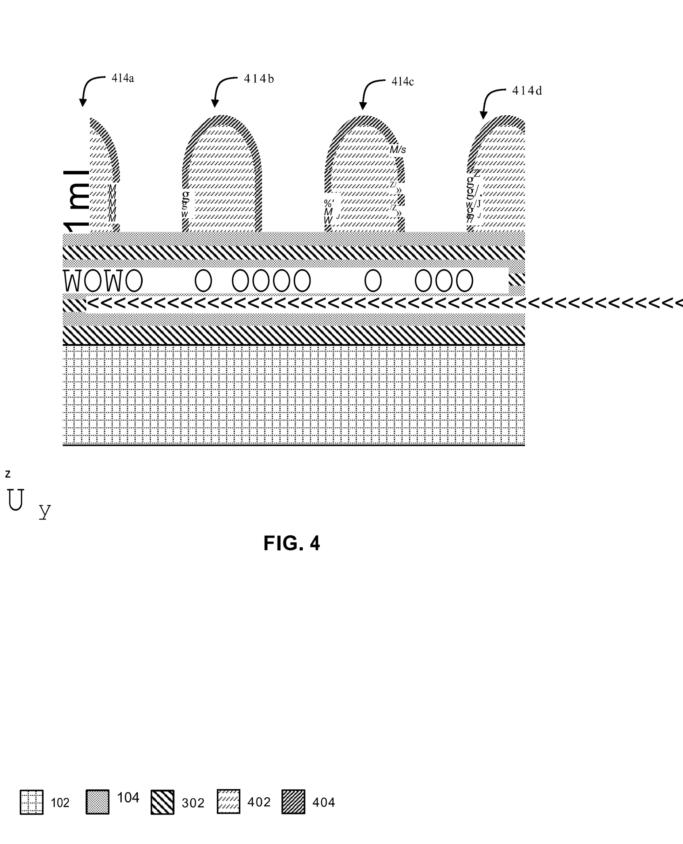

Returning to FIG. 2, at 204, a process to form dummy gates over the layers of channel material is performed. The dummy gates may be formed using photolithographic patterning processes, to deposit dummy gate materials in certain areas and not in others (or to remove dummy gate materials from certain areas but not from others). As illustrated in FIG. 4, a series of dummy gates 414 (including dummy gates 414a, 414b, 414c, and 414d) are formed over the alternating layers of the channel material 104 and the sacrificial material 302. The dummy gates 414 include a dummy gate material 402 and a gate spacer 404. The dummy gates 414 are spaced apart, at the locations for forming gates (e.g., the gate stack 116 in FIG. 1) later in the process. At a later part in the process, the dummy gates 414 and, in particular, the dummy gate material 402 is replaced with a gate stack. The gate spacer 404 may be included in a finished device, e.g., to electrically isolate the gate electrode from source or drain contacts formed on either side of the gate spacer 404.

The dummy gate material 402 and the gate spacer 404 may each be a dielectric material. Suitable dielectric materials may include low-k or high-k dielectrics including, but not limited to, elements such as hafnium, silicon, oxygen, nitrogen, titanium, tantalum, lanthanum, aluminum, zirconium, barium, strontium, yttrium, lead, scandium, niobium, and zinc. Further examples of dielectric materials include, but are not limited to silicon nitride, silicon oxide, silicon dioxide, silicon carbide, silicon nitride doped with carbon, silicon oxynitride, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, tantalum oxide, tantalum silicon oxide, lead scandium tantalum oxide, and lead zinc niobate.

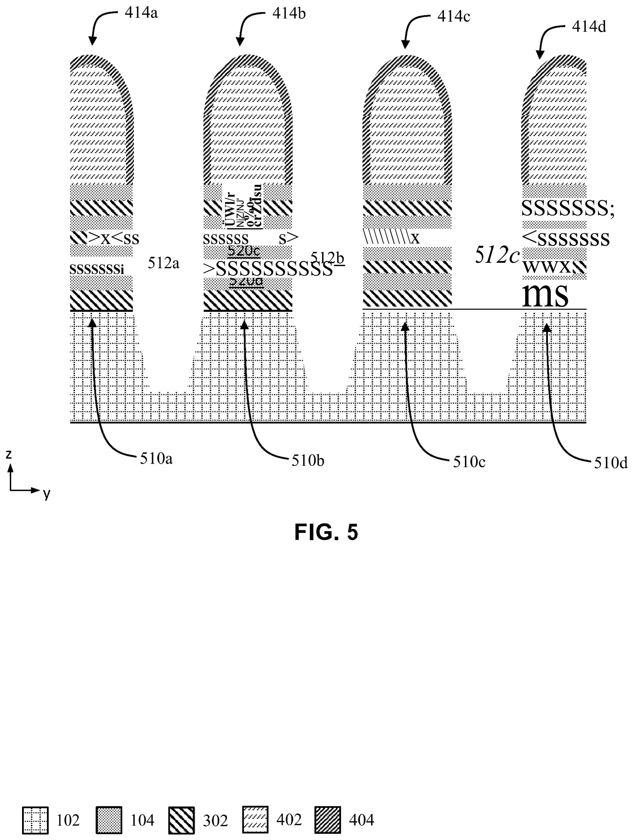

Returning to FIG. 2, at 206, a process to etch channel material to form individual stacks of nanoribbons for respective transistors is performed. FIG. 5 illustrates the nanoribbon channel material 104 after stacks have been etched to form individuated channels for different transistors. For example, the dummy gates 414 may act as a pattern, and portions of the alternating layers between the dummy gates 414 are removed, leaving the stacks 510a, 510b, 510c, and 510d illustrated in FIG. 5. Each stack 510 is under a respective dummy gate 414, e.g., the stack 510b is under the dummy gate 414b. The stacks 510 are separated by etched regions 512a, 512b, and 512c, e.g., the etched region 512a is between the stacks 510a and 510b. In this example, a portion of the support structure 102 is also etched, so that the etched regions 512 extend into the support structure 102. The regions 512 are regions in which the source and drain regions for transistors are formed.

In the example shown in FIG. 5, the channel material 104 is formed into four nanoribbons stacked on top of each other. For example, the stack 510b includes nanoribbons 520a, 520b, 520c, and 520d. Each nanoribbon 520 in the stack 510b is at a different height in the z-direction in the orientation shown in FIG. 5, i.e., a different distance from the support structure 102. Each of the stacks 510 has four nanoribbons. In other embodiments, the stacks 510, and transistors formed from the nanoribbon stacks, may each have fewer nanoribbons (e.g., two or three nanoribbons), or more than four nanoribbons (e.g., five nanoribbons, six nanoribbons, etc.). In this example, the sacrificial material 302 is below the lowest nanoribbon 520d (i.e., between the support structure 102 and the nanoribbon 520d) and between adjacent nanoribbons (e.g., between nanoribbon 520a and 520b, and between nanoribbon 520b and 520c). While not shown in FIG. 5, in some embodiments, a layer of the sacrificial material 302 is above the highest nanoribbon (i.e., between nanoribbon 520a and the dummy gate 414b).

The nanoribbons 520 each have an elongated structure that extends over the support structure 102. Each nanoribbon 520 extends primarily in the y-direction in the coordinate system used in FIGs. 3-12, and thus the nanoribbon structures are considered to be elongated in this direction. The direction in which the nanoribbons 520 extend is parallel to the support structure 102; this direction in which the nanoribbons 520 extend is also parallel to the other nanoribbons in the stack.

Returning to FIG. 2, at 208, a cavity etch process, also referred to as a dimple etch process, is performed. The cavity etch process removes a portion of the sacrificial material (e.g., the sacrificial material 302) between the nanoribbons, near the ends of the nanoribbons. A selective etch process is used that removes the sacrificial material while leaving other structures and materials (e.g., the nanoribbons 520, gate spacer 404, and support structure 102) substantially intact. The etch parameters are tuned to remove only a portion of the sacrificial material, while leaving the remainder of the sacrificial material in a central region of each stack 510. The etch process leaves a cavity (or dimple) into which the lined cavity spacer (or lined dimple spacer) may be formed.

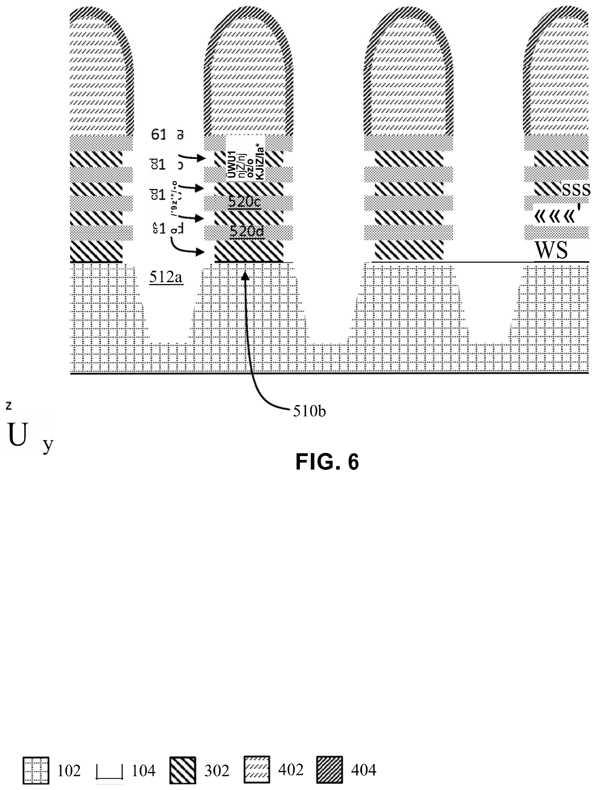

FIG. 6 is a cross-section illustrating the formation of cavities 610 between adjacent nanoribbons. A set of cavities 610 in the sacrificial material 302 are formed at either end of the nanoribbons 520. For example, the cavities 610a-610d are formed between and below the ends of the nanoribbons 520a-520d in the stack 510b, e.g., the cavity 610b is between the ends of the nanoribbons 520a and 520b. The cavities 610 are connected to the larger etched regions 512 between adjacent stacks of nanoribbons 520, e.g., the cavities 610a-610d are connected to the etched regions 512a.

Returning to FIG. 2, at 210, a first cavity spacer layer, or liner layer, is selectively deposited in the cavities formed in process 208. The first cavity spacer layer includes a first dielectric material. The first dielectric material does not include oxygen. The first cavity spacer layer is conformally deposited around the sidewalls of the cavities 610. For example, atomic layer deposition (ALD) or chemical vapor deposition (CVD) may be used to deposit the first dielectric material. Conformal deposition generally refers to deposition of a certain coating on any exposed surface of a given structure. A conformal coating may, therefore, be understood as a coating that is applied to exposed surfaces of a given structure, and not, for example, just to the horizontal surfaces.

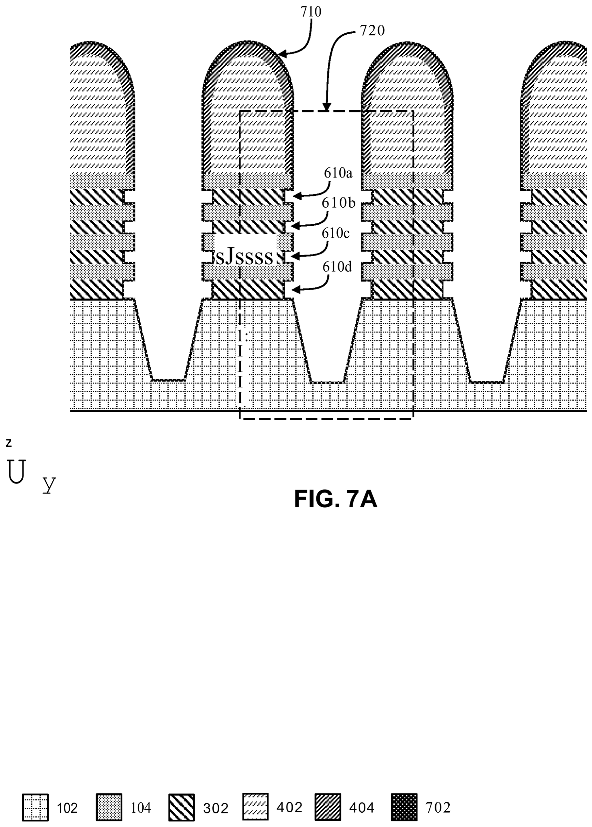

FIG. 7A is a cross-section illustrating deposition of a spacer liner material in the cavities. FIG. 7A illustrates a first dielectric material 702 formed along the exposed surfaces, including within the cavities 610. The first dielectric material 702 does not include oxygen. The first dielectric material 702 may include nitrogen. For example, the first dielectric material 702 may be a nitride, where nitrogen is combined with one or more other element. For example, the first dielectric material 702 may further include titanium (e.g., titanium nitride) or silicon (e.g., silicon nitride). In other embodiments, the first dielectric material 702 may include carbon (e.g., silicon carbide). More generally, the first dielectric material 702 may be a dielectric material that is selective to an oxide etch, i.e., the first dielectric material 702 is not etched away by an etch chemistry intended to remove oxygen.

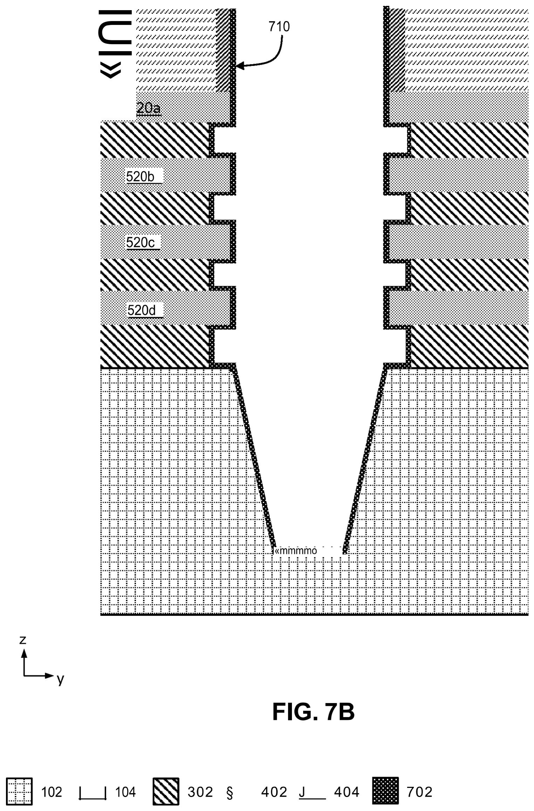

FIG. 7B is an enlarged view of the portion 720 of FIG. 7A. FIG. 7B more clearly shows the growth of the first dielectric material 702 in the cavities 610. A layer 710 of the first dielectric material 702 is formed along the exposed surfaces, including on the exposed sidewalls of the sacrificial material 302, and along the exposed portion of the upper and lower surfaces of the nanoribbons 520. In addition, layer 710 extends over the exposed sidewalls of the nanoribbons 520, along the gate spacer 404, and over the support structure 102.

Returning to FIG. 2, at 212, a second cavity spacer layer, or fill layer, is deposited over the first cavity spacer layer, or liner layer, formed in process 210. The second cavity spacer layer includes a second dielectric material, which may be a low-k dielectric material. The second dielectric material may be the same or different from the first dielectric material. The second cavity spacer layer, in combination with the previously deposited first cavity spacer layer, may fill or substantially fill the cavities 610. The second cavity spacer layer may be deposited using a conformal deposition process, as described above.

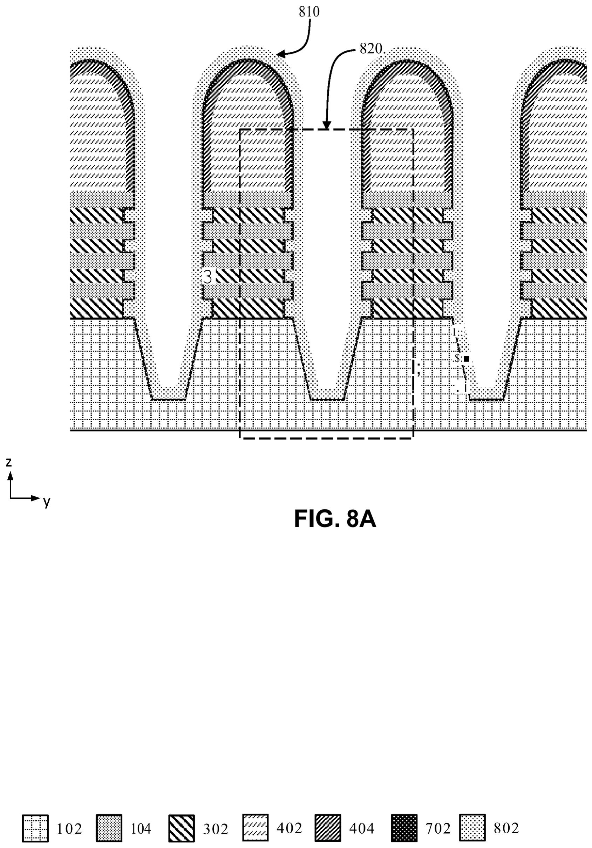

FIG. 8A illustrates deposition of a spacer fill material over the spacer liner material. In FIG. 8A, a second dielectric material 802 has been deposited within the cavities 610 and over the first dielectric material 702, as well as over the ends of the nanoribbons 520 and over the dummy gates 414. The second dielectric material 802 may be a low-k dielectric material. The second dielectric material 802 may include a combination of oxygen, silicon, nitrogen, and/or carbon. For example, the second dielectric material 802 may include silicon and carbon (e.g., silicon carbide), or silicon, carbon, and oxygen (e.g., silicon oxycarbide). In some embodiments, the second dielectric material 802 includes oxygen, and the first dielectric material 702 does not include oxygen. In many cases, nitrogen improves robustness of a dielectric material but raises the dielectric constant, so the first dielectric material 702 may include nitrogen (to resist the oxide removal process and protect the cavity spacer), and the second dielectric material 802 does not include nitrogen (to provide a low dielectric constant). In other embodiments, the first dielectric material 702 has a lower dielectric constant than the second dielectric material 802.

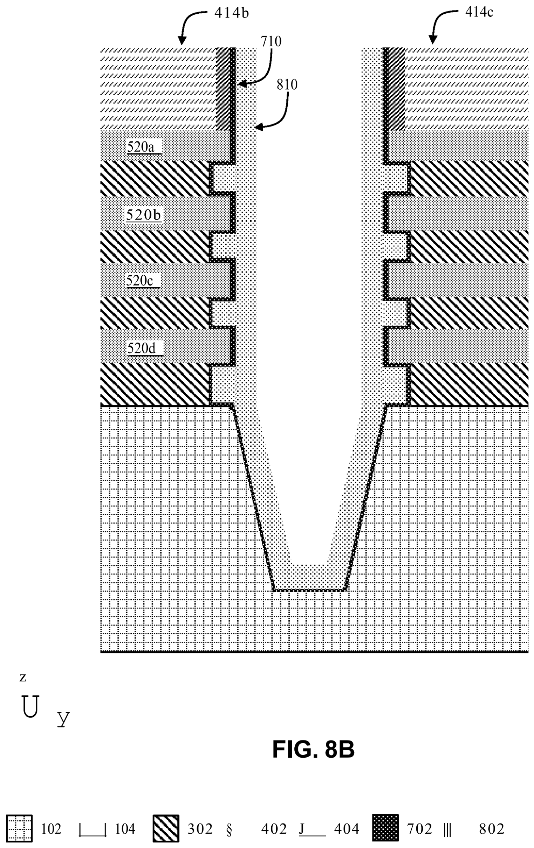

FIG. 8B is an enlarged view of the portion 820 of FIG. 8A. FIG. 8B more clearly shows the growth of the second dielectric material 802 in the cavities 610 and over the first dielectric material 702 in the cavities 610, as well as over the first dielectric material 702 that is over ends of the nanoribbons 520 and around the dummy gates 414. The second dielectric material 802 fills the cavities 610. Because the second dielectric material 802 is non-selectively deposited, the second dielectric material 802 is also deposited in regions outside of the cavities 610.

Returning to FIG. 2, at 214, spacer materials that were deposited outside of the cavities are etched. For example, an anisotropic liner etch is performed to remove the regions of the cavity spacer fill material outside of the cavities while leaving the regions of the cavity spacer fill material substantially intact. A second anisotropic liner etch may be performed to remove the regions of the first cavity spacer liner material outside of the cavities while leaving the regions of the cavity spacer liner material substantially intact. Atomic layer etch (ALE) processes may be used to remove the cavity spacer materials that are outside the cavities. ALE is a technique that removes material from a surface in thin layers, one layer at a time. ALE processes are often highly selective, so if the first and second dielectric materials 702 and 802 are different materials, a first etch chemistry may be used to remove the second dielectric material 802, followed by a second etch chemistry to remove the first dielectric material 702.

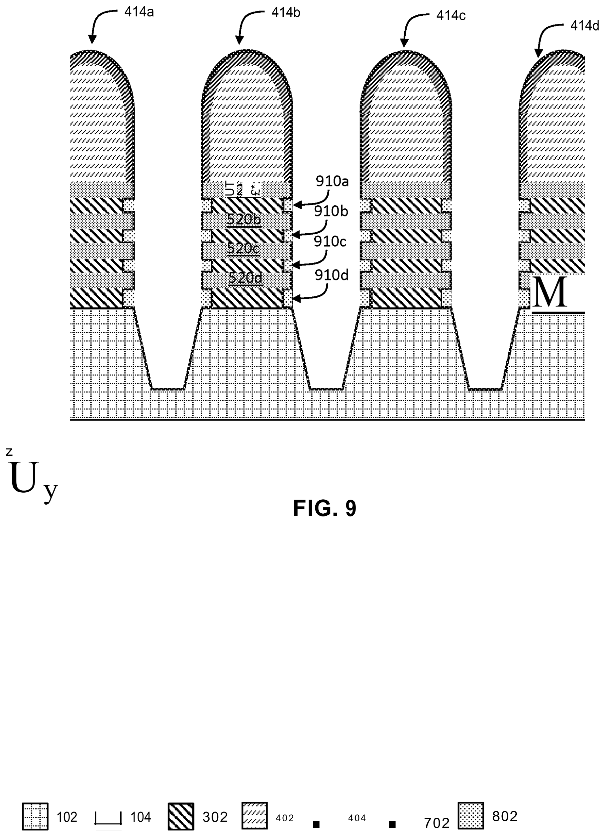

FIG. 9 is a cross-section illustrating removal of the spacer fill material from areas outside of the cavities. In FIG. 9, the second dielectric material 802 over the dummy gates 414, over the ends of the nanoribbons 520, and over the support structure 102 have been removed, e.g., by a first ALE process. The second dielectric material 802 within the cavities 610 remains. For example, the cavity spacer fill regions 910a, 910b, 910c, and 910d formed in the cavities 610a, 610b, 610c, and 610d remain after the spacer fill removal.

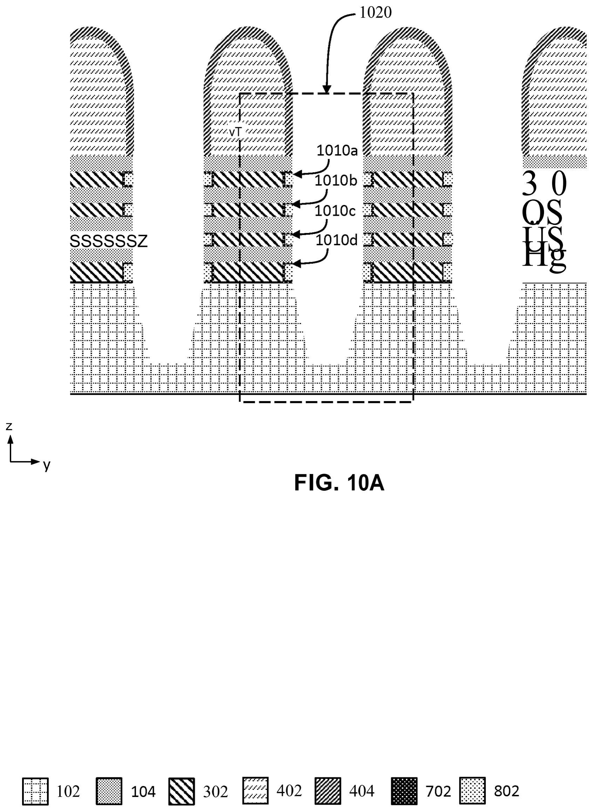

FIG. 10A is a cross-section illustrating removal of the spacer liner material from areas outside of the cavities, according to some embodiments of the present disclosure. In FIG. 9, the first dielectric material 702 over the dummy gates 414, over the ends of the nanoribbons 520, and over the support structure 102 have been removed, e.g., by a second ALE process. The first dielectric material 702 within the cavities 610 remains. For example, the cavity spacer liners 1010a, 1010b, 1010c, and 1010d formed in the cavities 610a, 610b, 610c, and 610d remain after the spacer fill removal.

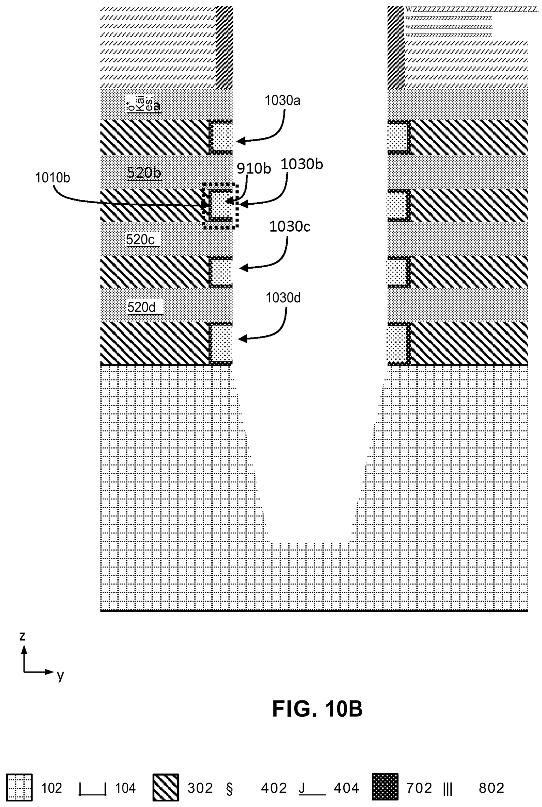

FIG. 10B is an enlarged view of a portion of FIG. 10A, according to some embodiments of the present disclosure. FIG. 10B more clearly shows the cavity spacers remaining after the ALE processes. FIG. 10B illustrates the cavity spacers 1030a, 1030b, 1030c, and 1030d formed within the cavities 610. Additional cavity spacers similar to cavity spacers 1030a, 1030b, 1030c, and 1030d are formed near opposite ends of each of the nanoribbon stacks, as shown in FIG. 10A. Each of the cavity spacers 1030a, 1030b, and 1030c is between a respective pair of the nanoribbons 520. The cavity spacer 1030d is between the nanoribbon 520d and the support structure 102.

Each cavity spacer 1030 includes a cavity spacer fill region 910 and a cavity spacer liner 1010. For example, the cavity spacer 1030b includes the cavity spacer liner 1010b of the first dielectric material 702 and a cavity spacer fill region 910b of the second dielectric material 802. In the cross-section shown in the figures, the cavity spacer liner 1010b includes a first portion over (in the y-direction) the cavity spacer fill regions 910b, a second portion under (in the y-direction) the cavity spacer fill region 910b, and a third portion between the sacrificial material 302 and a sidewall of the cavity spacer fill region 910b. The cavity spacer fill regions 910 are nested within the three portions of the cavity spacer liners 1010.

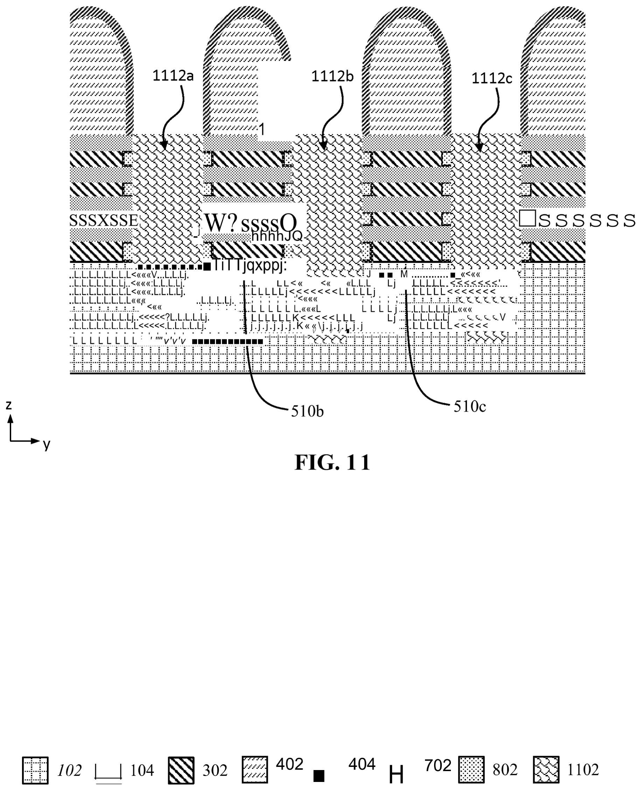

Returning to FIG. 2, at 216, source and drain material is deposited in the etched regions formed in the process 206. The source and drain material is grown over the ends of the nanoribbons 520, and is also grown over the cavity spacers 1030. FIG. 11 is a cross-section illustrating growth of sources and drains. FIG. 11 illustrates that an S/D material 1102 has been deposited in the spaces between the nanoribbons 520 and cavity spacers 1030, e.g., in the etched regions 512, forming the S/D contacts 1112a-1112c. The S/D material 1102 may include any of the materials described with respect to the S/D contacts 108. In this example, each S/D contact 1112 is shared by two transistors, each transistor formed around a respective nanoribbon stack 510. For example, the S/D contact 1112b is shared by the transistors formed around the nanoribbon stacks 1110b and 1110c; in one embodiment, the S/D contact 1112b is a drain contact for the nanoribbon stack 510b and a source contact for the nanoribbon stack 510c.

Returning to FIG. 2, at 218, a gate stack is formed around the nanoribbon stacks. For example, the remainder of the sacrificial material and the dummy gate material are removed, exposing the central portions of the nanoribbon channels. This etching process leaves the nanoribbon channels "floating" and supported by the S/D contacts and the cavity spacers. Prior to this etching process, an oxide etch or oxide clean step may be performed to remove any oxygen from the nanoribbon stacks 510, e.g., due to unintentional oxidization of a silicon channel material and/or silicon germanium sacrificial material. The non-oxide first dielectric material 702 is not removed during the oxide removal and protects the cavity spacers 1030 during the oxide removal. After the clean and etch processes, a gate stack including one or more gate dielectrics and one or more conductors are grown around the exposed portions of the nanoribbons.

FIG. 12A is a cross-section illustrating formation of the gate stack. FIG. 12 illustrates that the dummy gate material 402 has been removed (while the gate spacer 404 remains in an area above the S/D contacts 1112). The tops of the dummy gates 414 may have been removed in a polishing or planarization process, exposing the dummy gate material 402. The dummy gate material 402 may then be removed using a chemical etching process, e.g., a dry or wet etch. After removal of the dummy gate material 402, the sacrificial material 302 between the channel material 104 in the nanoribbon stacks 510 is removed, e.g., using a second etching process. After removal of the sacrificial material 302, gate material 1202 is grown around the centers of the nanoribbons 520, forming the gates 1210a-1210d. For example, the gate stack 1210b is formed around the nanoribbons 520a-520c. The gate material 1202 may include multiple gate materials grown in layers, e.g., a layer of dielectric directly over the nanoribbons 520 followed by a layer of a conductive material forming the gate electrode. For example, the gates 1210 may include the oxide 112, gate dielectric 114, and gate electrode 110 illustrated in FIG. 1 and described above.

FIG. 12B is an enlarged view of a portion 1220 of FIG. 12A, illustrating the lined cavity spacers in greater detail. The portion 1220 includes three nanoribbons 520b, 520c, and 520d, and four full cavity spacers 1030b, 1030c, 1030e, and 1030f. The portion 1220 includes the gate 1210b, which has four portions referred to as 1210b-1, 1210b-2, 1210b-3, and 1210b-4.

Each gate portion is adjacent to at least one nanoribbon 520. For example, the gate portion 1210b-2 is between the nanoribbons 520b and 520c, and the gate portion 1210b-3 is between the nanoribbons 520c and 520d. Each cavity spacer 1030 is within a same layer as one of the gate portions, and above and/or below at least one nanoribbon 520. For example, the cavity spacers 1030b and 1030e are in the same horizontal layer as the gate portion 1210b-2. Within this layer, the gate portion 1210b-2 is between the two cavity spacers 1030b and 1030e. Vertically, the cavity spacers 1030b and 1030e, and the gate portion 1210b-2, are between the nanoribbon 520b (which is over the layer with the cavity spacers 1030b and 1030e and the gate portion 1210b-2) and the nanoribbon 520c (which is under the layer with the cavity spacers 1030b and 1030e and the gate portion 1210b-2). Likewise, the cavity spacers 1030c and 1030f, and the gate portion 1210b-3, are between the nanoribbon 520c and the nanoribbon 520d. The gate portion 1210b-3 is between the cavity spacers 1030c and 1030f. Furthermore, the cavity spacers 1030 are between the gate 1210 and the S/D regions 1112, e.g., the cavity spacer 1030f is between the gate portion 1210b-3 and the S/D region 1112a, and the cavity spacer 1030c is between the gate portion 1210b-3 and the S/D region 1112b.

As described above, each cavity spacer 1030 has a first layer or liner layer that includes the first dielectric material 702, and each cavity spacer 1030 has a second layer or fill that includes the second dielectric material 802. Each cavity spacer 1030 may have a first portion along one nanoribbon 520, a second portion along another nanoribbon 520, and a third portion extending between the first portion and second portion (i.e., between the two nanoribbons), where the third portion is also adjacent to the gate stack 1210. For example, the cavity spacer 1030f has a first portion 1230 in contact with the nanoribbon 520c, a second portion 1232 in contact with the nanoribbon 520d, and a third portion 1234 that extends from the nanoribbon 520c to the nanoribbon 520d. The third portion 1234 is along a sidewall of the gate portion 1210b-3. The first portion 1230 is between the nanoribbon 520c and the cavity fill, the second portion 1232 is between the nanoribbon 520c and the cavity fill, and the third portion 1234 is between the gate portion 1210b-3 and the cavity fill.

The first dielectric material 702 (e.g., the portions 1230, 1232, and 1234) may each have a width of, e.g., less than 3 nanometers (nm), less than 2 nm, less than 1 nm, less than 0.8 nm, less than 0.5 nm, or less than 0.3 nm. The widths of the portions 1230, 1232, and 1234 may be measured outward from the cavity fill, i.e., in the z-direction for the portions 1230 and 1232, and in the y-direction for portion 1234. The widths of the portions 1230, 1232, and 1234 may be substantially uniform.

Each full cavity spacer, including the first dielectric material 702 and the second dielectric material 802, may have a width measured in the y-direction of, e.g., 4 to 40 nanometers or a range therein, e.g., 4-7 nm, 5-10 nm, 10-20 nm, 15-30 nm, 20-40 nm, etc. Each full cavity spacer, including the first dielectric material 702 and the second dielectric material 802, may have a height measured in the z-direction of, e.g., 2 to 15 nanometers or a range therein, e.g., 2-5 nm, 5-10 nm, 7-15 nm, etc. The cavity spacers 1030 may each have a depth measured in the x-direction of, e.g., 3 to 15 nanometers or a range therein, e.g., 3-6 nm, 5-10 nm, 7-15 nm, etc.

The nanoribbon 520b has a width 1240 measured in the y-direction, and the nanoribbon 520c has a width 1242 measured in the y-direction. The widths 1240 and 1242 may be substantially the same, e.g., within 3 nm, within 2 nm, within 1 nm, or within some other tolerance. The gate 1210b has a width 1244, where the width 1244 is less than the widths 1240 and 1242, e.g., at least 8 nm less, at least 10 nm less, at least 15 nm less, at least 20 nm less, at least 40 nm less, etc. A width 1246 extending across the gate 1210b (in particular, across the gate portion 1210b-3), across the cavity spacer 1030f (including both the liner and the fill), and across the cavity spacer 1030c (including both the liner and the fill) is substantially the same as the widths 1240 and 1242. For example, the widths 1240 and 1246 may within 5 nm, 3 nm, 2 nm, or 1 nm of each other, or within some other tolerance.

Furthermore, the edges of the nanoribbons 520, cavity spacer liners (e.g., the first portion 1230 and second portion 1232 of the cavity spacer 1030f), and the cavity spacer fill (e.g., the fill of the cavity spacer 1030f) are substantially aligned. For example, in the orientation of FIG. 12B, the left edges of the nanoribbons 520b and 520c are aligned with the left edges of the first portion 1230 and second portion 1232 of the 1030f and with the left edge of the fill of the cavity spacer 1030f. Said another way, a right edge of the 1112a may be substantially vertical along the nanoribbons 520 and the cavity spacers 1030.

In FIGs. 11 and 12, the gate 1210 is illustrated using a single pattern. As described above, in some cases, the gate 1210 may be a gate stack that includes one or more gate dielectrics (e.g., the oxide 112 and high-k dielectric 114) as well as a conductive material, e.g., the gate electrode 110. FIG. 13 is a cross-section illustrating lined cavity spacers adjacent to a gate stack with a gate dielectric, according to some embodiments of the present disclosure. FIG. 13 illustrates the same portion 1220 of FIG. 12A, only in FIG. 13, the gate 1210b is illustrated with a gate electrode 1302 and a gate dielectric 1304. The gate electrode 1302 may be similar to the gate electrode 110 described with respect to FIG. 1. The gate dielectric 1304 may include the oxide 112 and/or high-k dielectric 114 described with respect to FIG. 1.

In the example shown in FIG. 13, portions of the gate dielectric 1304 are along the cavity spacers 1030, between the gate electrode 1302 and the cavity spacers 1030. For example, a portion 1310 of the gate dielectric 1304 is between the third portion 1234 of the cavity spacer liner and the gate electrode 1302. In such embodiments, the gate dielectric 1304 may have been non-selectively conformally deposited, e.g., using ALD or CVD. In other embodiments, the gate dielectric 1304 may be selectively deposited, such that the gate dielectric 1304 only forms over the nanoribbons 520, and not along the cavity spacers 1030. For example, the gate dielectric 1304 may be deposited using area selective deposition (ASD) or area selective atomic layer deposition (AS-ALD). In such embodiments, the cavity spacers 1030 (and particularly, the first dielectric material 702 forming the liner of the cavity spacers 1030) may be in direct contact with the gate electrode 1302.

### Example devices

The circuit devices with nanoribbon transistors with lined cavity spacers disclosed herein may be included in any suitable electronic device. FIGS. 14-17 illustrate various examples of apparatuses that may include the one or more transistors disclosed herein, which may have been fabricated using the processes disclosed herein.

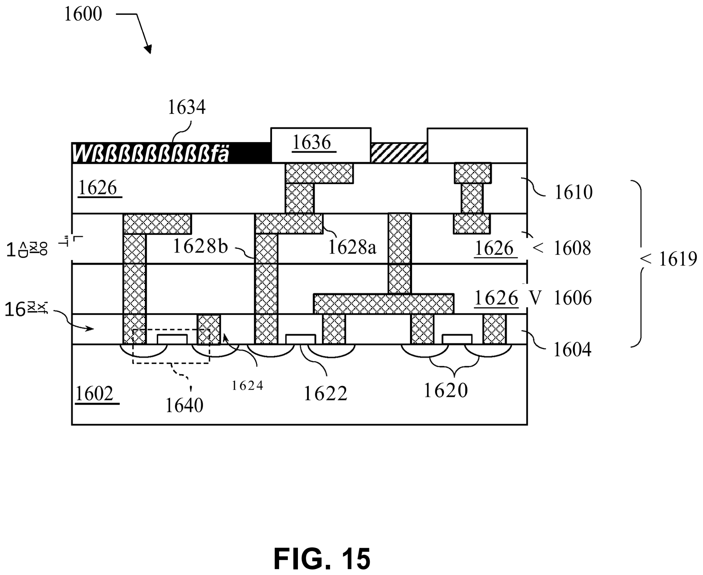

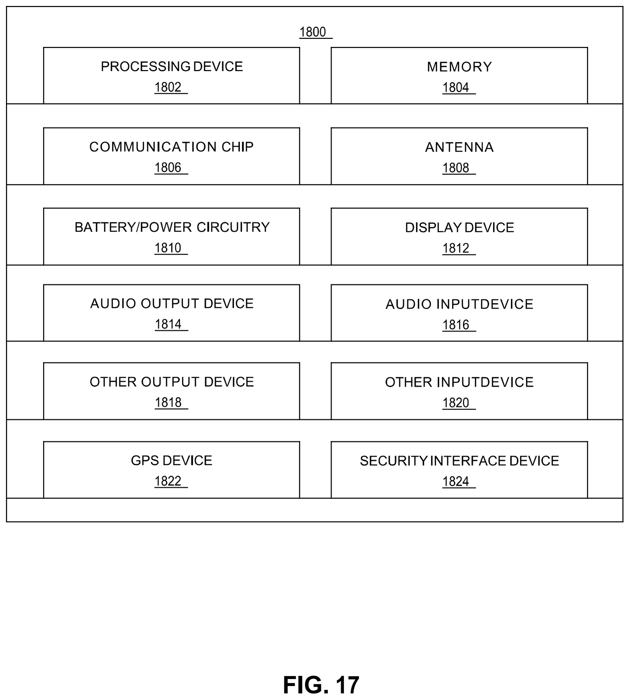

FIG. 14A and 14B are top views of a wafer and dies that include one or more IC structures including one or more nanoribbon transistors with lined cavity spacers in accordance with any of the embodiments disclosed herein. The wafer 1500 may be composed of semiconductor material and may include one or more dies 1502 having IC structures formed on a surface of the wafer 1500. Each of the dies 1502 may be a repeating unit of a semiconductor product that includes any suitable IC structure (e.g., the IC structures as shown in any of FIGS. 2-14, or any further embodiments of the IC structures described herein). After the fabrication of the semiconductor product is complete (e.g., after manufacture of one or more IC structures with one or more of the transistors as described herein, included in a particular electronic component, e.g., in a transistor or in a memory device), the wafer 1500 may undergo a singulation process in which each of the dies 1502 is separated from one another to provide discrete "chips" of the semiconductor product. In particular, devices that include one or more of the transistors as disclosed herein may take the form of the wafer 1500 (e.g., not singulated) or the form of the die 1502 (e.g., singulated). The die 1502 may include one or more transistors (e.g., one or more of the transistors 1640 of FIG. 15, discussed below) and/or supporting circuitry to route electrical signals to the transistors, as well as any other IC components (e.g., one or more of the non-planar transistors described herein). In some embodiments, the wafer 1500 or the die 1502 may include a memory device (e.g., an SRAM device), a logic device (e.g., an AND, OR, NAND, or NOR gate), or any other suitable circuit element. Multiple ones of these devices may be combined on a single die 1502. For example, a memory array formed by multiple memory devices may be formed on a same die 1502 as a processing device (e.g., the processing device 1802 of FIG. 17) or other logic that is configured to store information in the memory devices or execute instructions stored in the memory array.

FIG. 15 is a cross-sectional side view of an IC device 1600 that may include one or more nanoribbon transistors with lined cavity spacers in accordance with any of the embodiments disclosed herein. The IC device 1600 may be formed on a substrate 1602 (e.g., the wafer 1500 of FIG. 14A) and may be included in a die (e.g., the die 1502 of FIG. 14B). The substrate 1602 may be any substrate as described herein. The substrate 1602 may be part of a singulated die (e.g., the dies 1502 of FIG. 14B) or a wafer (e.g., the wafer 1500 of FIG. 14A).

The IC device 1600 may include one or more device layers 1604 disposed on the substrate 1602. The device layer 1604 may include features of one or more transistors 1640 (e.g., metal-oxide-semiconductor field-effect transistors (MOSFETs)) formed on the substrate 1602. The device layer 1604 may include, for example, one or more source and/or drain (S/D) regions 1620, a gate 1622 to control current flow in the transistors 1640 between the S/D regions 1620, and one or more S/D contacts 1624 to route electrical signals to/from the S/D regions 1620. The transistors 1640 may include additional features not depicted for the sake of clarity, such as device isolation regions, gate contacts, and the like. The transistors 1640 are not limited to the type and configuration depicted in FIG. 15 and may include a wide variety of other types and configurations such as, for example, planar transistors, non-planar transistors, or a combination of both. Non-planar transistors may include FinFET transistors, such as double-gate transistors or tri-gate transistors, and wrap-around or all-around gate transistors, such as nanoribbon and nanowire transistors.

Each transistor 1640 may include a gate 1622 formed of at least two layers, a gate electrode layer and a gate dielectric layer.

The gate electrode layer may be formed on the gate interconnect support layer and may consist of at least one P-type workfunction metal or N-type workfunction metal, depending on whether the transistor is to be a PMOS or an NMOS transistor, respectively. In some implementations, the gate electrode layer may consist of a stack of two or more metal layers, where one or more metal layers are workfunction metal layers and at least one metal layer is a fill metal layer. Further metal layers may be included for other purposes, such as a barrier layer or/and an adhesion layer.

For a PMOS transistor, metals that may be used for the gate electrode include, but are not limited to, ruthenium, palladium, platinum, cobalt, nickel, and conductive metal oxides, e.g., ruthenium oxide. A P-type metal layer will enable the formation of a PMOS gate electrode with a workfunction that is between about 4.9 electron Volts (eV) and about 5.2 eV. For an NMOS transistor, metals that may be used for the gate electrode include, but are not limited to, hafnium, zirconium, titanium, tantalum, aluminum, alloys of these metals, and carbides of these metals such as hafnium carbide, zirconium carbide, titanium carbide, tantalum carbide, aluminum carbide, tungsten, tungsten carbide. An N-type metal layer will enable the formation of an NMOS gate electrode with a workfunction that is between about 3.9 eV and about 4.2 eV.

In some embodiments, when viewed as a cross-section of the transistor 1640 along the source-channel-drain direction, the gate electrode may be formed as a U-shaped structure that includes a bottom portion substantially parallel to the surface of the substrate and two sidewall portions that are substantially perpendicular to the top surface of the substrate. In other embodiments, at least one of the metal layers that form the gate electrode may simply be a planar layer that is substantially parallel to the top surface of the substrate and does not include sidewall portions substantially perpendicular to the top surface of the substrate. In other embodiments, the gate electrode may be implemented as a combination of U-shaped structures and planar, non-U-shaped structures. For example, the gate electrode may be implemented as one or more U-shaped metal layers formed atop one or more planar, non-U-shaped layers. In some embodiments, the gate electrode may consist of a V-shaped structure (e.g., when a fin of a FinFET transistor does not have a "flat" upper surface, but instead has a rounded peak).

Generally, the gate dielectric layer of a transistor 1640 may include one layer or a stack of layers, and the one or more layers may include silicon oxide, silicon dioxide, and/or a high-k dielectric material. The high-k dielectric material included in the gate dielectric layer of the transistor 1640 may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric layer include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric layer to improve its quality when a high-k material is used.

The IC device 1600 may include one or more nanoribbon transistors with lined cavity spacers at any suitable location in the IC device 1600.

The S/D regions 1620 may be formed within the substrate 1602 adjacent to the gate 1622 of each transistor 1640, using any suitable processes known in the art. For example, the S/D regions 1620 may be formed using either an implantation/diffusion process or a deposition process. In the former process, dopants such as boron, aluminum, antimony, phosphorous, or arsenic may be ion-implanted into the substrate 1602 to form the S/D regions 1620. An annealing process that activates the dopants and causes them to diffuse farther into the substrate 1602 may follow the ion implantation process. In the latter process, an epitaxial deposition process may provide material that is used to fabricate the S/D regions 1620. In some implementations, the S/D regions 1620 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 1620 may be formed using one or more alternate semiconductor materials such as germanium or a group III-V material or alloy. In further embodiments, one or more layers of metal and/or metal alloys may be used to form the S/D regions 1620. In some embodiments, an etch process may be performed before the epitaxial deposition to create recesses in the substrate 1602 in which the material for the S/D regions 1620 is deposited.

Electrical signals, such as power and/or input/output (I/O) signals, may be routed to and/or from the transistors 1640 of the device layer 1604 through one or more interconnect layers disposed on the device layer 1604 (illustrated in FIG. 15 as interconnect layers 1606-1610). For example, electrically conductive features of the device layer 1604 (e.g., the gate 1622 and the S/D contacts 1624) may be electrically coupled with the interconnect structures 1628 of the interconnect layers 1606-1610. The one or more interconnect layers 1606-1610 may form an ILD stack 1619 of the IC device 1600.

The interconnect structures 1628 may be arranged within the interconnect layers 1606-1610 to route electrical signals according to a wide variety of designs (in particular, the arrangement is not limited to the particular configuration of interconnect structures 1628 depicted in FIG. 15). Although a particular number of interconnect layers 1606-1610 is depicted in FIG. 15, embodiments of the present disclosure include IC devices having more or fewer interconnect layers than depicted.

In some embodiments, the interconnect structures 1628 may include trench contact structures 1628a (sometimes referred to as "lines") and/or via structures 1628b (sometimes referred to as "holes") filled with an electrically conductive material such as a metal. The trench contact structures 1628a may be arranged to route electrical signals in a direction of a plane that is substantially parallel with a surface of the substrate 1602 upon which the device layer 1604 is formed. For example, the trench contact structures 1628a may route electrical signals in a direction in and out of the page from the perspective of FIG. 15. The via structures 1628b may be arranged to route electrical signals in a direction of a plane that is substantially perpendicular to the surface of the substrate 1602 upon which the device layer 1604 is formed. In some embodiments, the via structures 1628b may electrically couple trench contact structures 1628a of different interconnect layers 1606-1610 together.

The interconnect layers 1606-1610 may include a dielectric material 1626 disposed between the interconnect structures 1628, as shown in FIG. 15. The dielectric material 1626 may take the form of any of the embodiments of the dielectric material provided between the interconnects of the IC structures disclosed herein.

In some embodiments, the dielectric material 1626 disposed between the interconnect structures 1628 in different ones of the interconnect layers 1606-1610 may have different compositions. In other embodiments, the composition of the dielectric material 1626 between different interconnect layers 1606-1610 may be the same.

A first interconnect layer 1606 (referred to as Metal 1 or "M1") may be formed directly on the device layer 1604. In some embodiments, the first interconnect layer 1606 may include trench contact structures 1628a and/or via structures 1628b, as shown. The trench contact structures 1628a of the first interconnect layer 1606 may be coupled with contacts (e.g., the S/D contacts 1624) of the device layer 1604.

A second interconnect layer 1608 (referred to as Metal 2 or "M2") may be formed directly on the first interconnect layer 1606. In some embodiments, the second interconnect layer 1608 may include via structures 1628b to couple the trench contact structures 1628a of the second interconnect layer 1608 with the trench contact structures 1628a of the first interconnect layer 1606. Although the trench contact structures 1628a and the via structures 1628b are structurally delineated with a line within each interconnect layer (e.g., within the second interconnect layer 1608) for the sake of clarity, the trench contact structures 1628a and the via structures 1628b may be structurally and/or materially contiguous (e.g., simultaneously filled during a dual-damascene process) in some embodiments.

A third interconnect layer 1610 (referred to as Metal 3 or "M3") (and additional interconnect layers, as desired) may be formed in succession on the second interconnect layer 1608 according to similar techniques and configurations described in connection with the second interconnect layer 1608 or the first interconnect layer 1606.

The IC device 1600 may include a solder resist material 1634 (e.g., polyimide or similar material) and one or more bond pads 1636 formed on the interconnect layers 1606-1610. The bond pads 1636 may be electrically coupled with the interconnect structures 1628 and configured to route the electrical signals of the transistor(s) 1640 to other external devices. For example, solder bonds may be formed on the one or more bond pads 1636 to mechanically and/or electrically couple a chip including the IC device 1600 with another component (e.g., a circuit board). The IC device 1600 may have other alternative configurations to route the electrical signals from the interconnect layers 1606-1610 than depicted in other embodiments. For example, the bond pads 1636 may be replaced by or may further include other analogous features (e.g., posts) that route the electrical signals to external components.

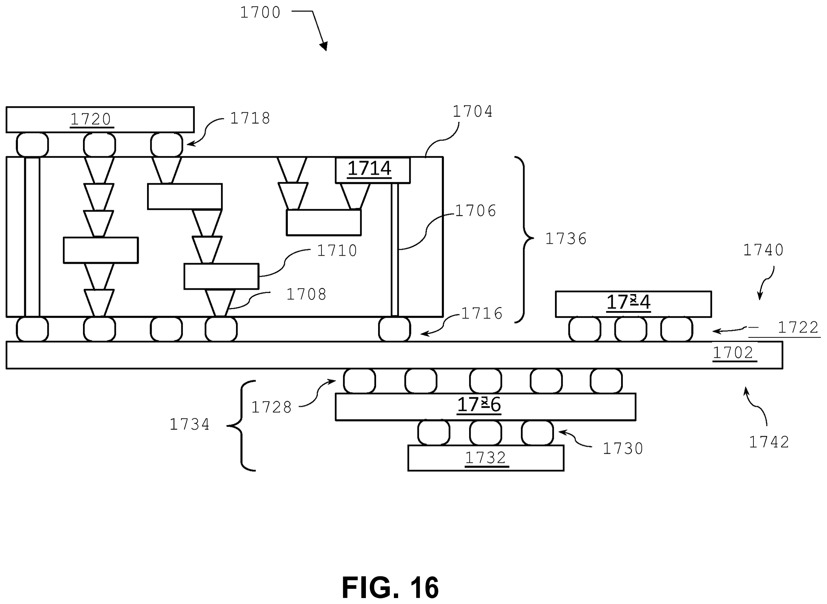

FIG. 16 is a cross-sectional side view of an IC device assembly 1700 that may include components having or being associated with (e.g., being electrically connected by means of) one or more nanoribbon transistors with lined cavity spacers in accordance with any of the embodiments disclosed herein. The IC device assembly 1700 includes a number of components disposed on a circuit board 1702 (which may be, e.g., a motherboard). The IC device assembly 1700 includes components disposed on a first face 1740 of the circuit board 1702 and an opposing second face 1742 of the circuit board 1702; generally, components may be disposed on one or both faces 1740 and 1742. In particular, any suitable ones of the components of the IC device assembly 1700 may include one or more of the non-planar transistors disclosed herein.

In some embodiments, the circuit board 1702 may be a printed circuit board (PCB) including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 1702. In other embodiments, the circuit board 1702 may be a non-PCB substrate.

The IC device assembly 1700 illustrated in FIG. 16 includes a package-on-interposer structure 1736 coupled to the first face 1740 of the circuit board 1702 by coupling components 1716. The coupling components 1716 may electrically and mechanically couple the package-on-interposer structure 1736 to the circuit board 1702 and may include solder balls (as shown in FIG. 16), male and female portions of a socket, an adhesive, an underfill material, and/or any other suitable electrical and/or mechanical coupling structure.

The package-on-interposer structure 1736 may include an IC package 1720 coupled to an interposer 1704 by coupling components 1718. The coupling components 1718 may take any suitable form for the application, such as the forms discussed above with reference to the coupling components 1716. Although a single IC package 1720 is shown in FIG. 16, multiple IC packages may be coupled to the interposer 1704; indeed, additional interposers may be coupled to the interposer 1704. The interposer 1704 may provide an intervening substrate used to bridge the circuit board 1702 and the IC package 1720. The IC package 1720 may be or include, for example, a die (the die 1502 of FIG. 14B), an IC device (e.g., the IC device 1600 of FIG. 15), or any other suitable component. In some embodiments, the IC package 1720 may include one or more nanoribbon transistors with lined cavity spacers, as described herein. Generally, the interposer 1704 may spread a connection to a wider pitch or reroute a connection to a different connection. For example, the interposer 1704 may couple the IC package 1720 (e.g., a die) to a ball grid array (BGA) of the coupling components 1716 for coupling to the circuit board 1702. In the embodiment illustrated in FIG. 16, the IC package 1720 and the circuit board 1702 are attached to opposing sides of the interposer 1704; in other embodiments, the IC package 1720 and the circuit board 1702 may be attached to a same side of the interposer 1704. In some embodiments, three or more components may be interconnected by way of the interposer 1704.

The interposer 1704 may be formed of an epoxy resin, a fiberglass-reinforced epoxy resin, a ceramic material, or a polymer material such as polyimide. In some implementations, the interposer 1704 may be formed of alternate rigid or flexible materials that may include the same materials described above for use in a semiconductor substrate, such as silicon, germanium, and other group III-V and group IV materials. The interposer 1704 may include metal interconnects 1708 and vias 1710, including but not limited to TSVs 1706. The interposer 1704 may further include embedded devices 1714, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency (RF) devices, power amplifiers, power management devices, antennas, arrays, sensors, and microelectromechanical systems (MEMS) devices may also be formed on the interposer 1704. The package-on-interposer structure 1736 may take the form of any of the package-on-interposer structures known in the art.

The IC device assembly 1700 may include an IC package 1724 coupled to the first face 1740 of the circuit board 1702 by coupling components 1722. The coupling components 1722 may take the form of any of the embodiments discussed above with reference to the coupling components 1716, and the IC package 1724 may take the form of any of the embodiments discussed above with reference to the IC package 1720.

The IC device assembly 1700 illustrated in FIG. 16 includes a package-on-package structure 1734 coupled to the second face 1742 of the circuit board 1702 by coupling components 1728. The package-on-package structure 1734 may include an IC package 1726 and an IC package 1732 coupled together by coupling components 1730 such that the IC package 1726 is disposed between the circuit board 1702 and the IC package 1732. The coupling components 1728 and 1730 may take the form of any of the embodiments of the coupling components 1716 discussed above, and the IC packages 1726 and 1732 may take the form of any of the embodiments of the IC package 1720 discussed above. The package-on-package structure 1734 may be configured in accordance with any of the package-on-package structures known in the art.

FIG. 17 is a block diagram of an example computing device 1800 that may include one or more nanoribbon transistors with lined cavity spacers in accordance with any of the embodiments disclosed herein. For example, any suitable ones of the components of the computing device 1800 may include a die (e.g., the die 1502 (FIG. 14B)) having one or more nanoribbon transistors with lined cavity spacers. Any one or more of the components of the computing device 1800 may include, or be included in, an IC device 1600 (FIG. 15). Any one or more of the components of the computing device 1800 may include, or be included in, an IC device assembly 1700 (FIG. 16).

A number of components are illustrated in FIG. 17 as included in the computing device 1800, but any one or more of these components may be omitted or duplicated, as suitable for the application. In some embodiments, some or all of the components included in the computing device 1800 may be attached to one or more motherboards. In some embodiments, some or all of these components are fabricated onto a single system-on-a-chip (SoC) die.

Additionally, in various embodiments, the computing device 1800 may not include one or more of the components illustrated in FIG. 17, but the computing device 1800 may include interface circuitry for coupling to the one or more components. For example, the computing device 1800 may not include a display device 1812, but may include display device interface circuitry (e.g., a connector and driver circuitry) to which a display device 1812 may be coupled. In another set of examples, the computing device 1800 may not include an audio input device 1816 or an audio output device 1814, but may include audio input or output device interface circuitry (e.g., connectors and supporting circuitry) to which an audio input device 1816 or audio output device 1814 may be coupled.

The computing device 1800 may include a processing device 1802 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 1802 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices. The computing device 1800 may include a memory 1804, which may itself include one or more memory devices such as volatile memory (e.g., dynamic random access memory (DRAM)), nonvolatile memory (e.g., read-only memory (ROM)), flash memory, solid state memory, and/or a hard drive. In some embodiments, the memory 1804 may include memory that shares a die with the processing device 1802. This memory may be used as cache memory and may include embedded dynamic random access memory (eDRAM) or spin transfer torque magnetic random access memory (STT-MRAM).

In some embodiments, the computing device 1800 may include a communication chip 1806 (e.g., one or more communication chips). For example, the communication chip 1806 may be configured for managing wireless communications for the transfer of data to and from the computing device 1800. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

The communication chip 1806 may implement any of a number of wireless standards or protocols, including but not limited to Institute for Electrical and Electronic Engineers (IEEE) standards including Wi-Fi (IEEE 1402.11 family), IEEE 1402.18 standards (e.g., IEEE 1402.18-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 1402.18 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 1402.18 standards. The communication chip 1806 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 1806 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 1806 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 1806 may operate in accordance with other wireless protocols in other embodiments. The computing device 1800 may include an antenna 1808 to facilitate wireless communications and/or to receive other wireless communications (such as AM or FM radio transmissions).

In some embodiments, the communication chip 1806 may manage wired communications, such as electrical, optical, or any other suitable communication protocols (e.g., the Ethernet). As noted above, the communication chip 1806 may include multiple communication chips. For instance, a first communication chip 1806 may be dedicated to shorter-range wireless communications such as Wi-Fi or Bluetooth, and a second communication chip 1806 may be dedicated to longer-range wireless communications such as GPS, EDGE, GPRS, CDMA, WiMAX, LTE, EV-DO, or others. In some embodiments, a first communication chip 1806 may be dedicated to wireless communications, and a second communication chip 1806 may be dedicated to wired communications.

The computing device 1800 may include a battery/power circuitry 1810. The battery/power circuitry 1810 may include one or more energy storage devices (e.g., batteries or capacitors) and/or circuitry for coupling components of the computing device 1800 to an energy source separate from the computing device 1800 (e.g., AC line power).

The computing device 1800 may include a display device 1812 (or corresponding interface circuitry, as discussed above). The display device 1812 may include any visual indicators, such as a heads-up display, a computer monitor, a projector, a touchscreen display, a liquid crystal display (LCD), a light-emitting diode display, or a flat panel display, for example.

The computing device 1800 may include an audio output device 1814 (or corresponding interface circuitry, as discussed above). The audio output device 1814 may include any device that generates an audible indicator, such as speakers, headsets, or earbuds, for example.

The computing device 1800 may include an audio input device 1816 (or corresponding interface circuitry, as discussed above). The audio input device 1816 may include any device that generates a signal representative of a sound, such as microphones, microphone arrays, or digital instruments (e.g., instruments having a musical instrument digital interface (MIDI) output).

The computing device 1800 may include another output device 1818 (or corresponding interface circuitry, as discussed above). Examples of the other output device 1818 may include an audio codec, a video codec, a printer, a wired or wireless transmitter for providing information to other devices, or an additional storage device.

The computing device 1800 may include another input device 1820 (or corresponding interface circuitry, as discussed above). Examples of the other input device 1820 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The computing device 1800 may include a global positioning system (GPS) device 1822 (or corresponding interface circuitry, as discussed above). The GPS device 1822 may be in communication with a satellite-based system and may receive a location of the computing device 1800, as known in the art.

The computing device 1800 may include a security interface device 1824. The security interface device 1824 may include any device that provides security features for the computing device 1800 or for any individual components therein (e.g., for the processing device 1802 or for the memory 1804). Examples of security features may include authorization, access to digital certificates, access to items in keychains, etc. Examples of the security interface device 1824 may include a software firewall, a hardware firewall, an antivirus, a content filtering device, or an intrusion detection device.

The computing device 1800 may have any desired form factor, such as a hand-held or mobile computing device (e.g., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device. In some embodiments, the computing device 1800 may be any other electronic device that processes data.

### Select examples

The following paragraphs provide various examples of the embodiments disclosed herein.

Example 1 provides an integrated circuit (IC) device including a first semiconductor structure; a second semiconductor structure, the first semiconductor structure and the second semiconductor structure arranged in a stack; a gate between the first semiconductor structure and the second semiconductor structure; and a spacer between the first semiconductor structure and the second semiconductor structure, the spacer including a first layer having a first portion in contact with the first semiconductor structure, a second portion in contact with the second semiconductor structure, and a third portion along the gate, where the first layer does not include oxygen; and a second layer nested within the first layer.

Example 2 provides the IC device of example 1, where the first portion of the first layer of the spacer is between the second layer of the spacer and the first semiconductor structure, and the second portion of the first layer of the spacer is between the second layer of the spacer and the second semiconductor structure.

Example 3 provides the IC device of example 1 or 2, where an edge of the first layer of the spacer, an edge of the second layer of the spacer, an edge of the first semiconductor structure, and an edge of the second semiconductor structure are aligned.

Example 4 provides the IC device of any preceding example, where the first layer includes nitrogen.

Example 5 provides the IC device of example 4, where the first layer includes titanium.

Example 6 provides the IC device of example 4, where the first layer includes silicon.

Example 7 provides the IC device of any preceding example, where the first layer includes carbon.

Example 8 provides the IC device of any preceding example, where the first layer includes a low-k material.

Example 9 provides the IC device of any preceding example, where the first layer includes a first material, the second layer includes a second material, and a first dielectric constant of the first material is less than a second dielectric constant of the second material.

Example 10 provides the IC device of any preceding example, where the first layer has a thickness of less than 2 nanometers.

Example 11 provides the IC device of any preceding example, where the spacer is a first spacer, the IC device further includes a second spacer between the first semiconductor structure and the second semiconductor structure, and the gate is between the first spacer and the second spacer.

Example 12 provides the IC device of any preceding example, where the second layer includes oxygen.

Example 13 provides the IC device of any preceding examples, further including a source or drain region, the spacer between the source or drain region and the gate.

Example 14 provides the IC device of any preceding examples, where the gate includes a dielectric layer and a conductive layer, and the first layer of the spacer is between the dielectric layer of the gate and the second layer of the spacer.

Example 15 provides an integrated circuit (IC) device including a first nanoribbon; a second nanoribbon stacked over the first nanoribbon, where the first nanoribbon and the second nanoribbon each have a first width; a conductive structure between the first nanoribbon and the second nanoribbon, the conductive structure having a second width less than the first width; a dielectric spacer between the first nanoribbon and the second nanoribbon, the dielectric spacer in a same layer as the conductive structure; and a liner between the dielectric spacer and the first nanoribbon, between the dielectric spacer and the second nanoribbon, and between the dielectric spacer and the conductive structure, where the liner includes nitrogen.

Example 16 provides the IC device of example 15, where the liner has a thickness of less than 2 nanometers.

Example 17 provides the IC device of example 15 or 16, where the dielectric spacer is a first dielectric spacer and the liner is a first liner, and the IC device further includes a second dielectric spacer between the first nanoribbon and the second nanoribbon, the second dielectric spacer on an opposite side of the conductive structure from the first dielectric spacer; and a second liner between the second dielectric spacer and the first nanoribbon, between the second dielectric spacer and the second nanoribbon, and between the second dielectric spacer and the conductive structure, where the second liner includes nitrogen.

Example 18 provides the IC device of example 17, where a third width across the first dielectric spacer, the first liner, the conductive structure, the second liner, and the second dielectric spacer is equal to the first width.

Example 19 provides the IC device of any of examples 15-18, further including a dielectric material between the first nanoribbon and the conductive structure and between the second nanoribbon and the conductive structure.

Example 20 provides the IC device of example 19, where the dielectric material is further between the liner and the conductive structure.

Example 21 provides a method including providing a stack of elongated structures of a first material with regions of a second material between adjacent ones of the elongated structure, each elongated structure in the stack having a first end and a second end; etching portions of the second material from the first end of the stack and the second end of the stack to form a first plurality of cavities at the first end and a second plurality of cavities at the second end; depositing a first spacer material in first plurality of cavities and the second plurality of cavities, the first spacer material lining an upper portion, side portion, and lower portion of one of the cavities; and depositing a second spacer material over the first spacer material, the second spacer material filling the one of the cavities.

Example 22 provides the method of example 21, further including removing the first spacer material and the second spacer material from the ends of the stack of elongated structures, where the first spacer material and the second spacer material remain in the first plurality of cavities and the second plurality of cavities.

Example 23 provides an IC package that includes an IC die, including one or more of the IC devices according to any one of the preceding examples. The IC package may also include a further component, coupled to the IC die.

Example 24 provides the IC package according to example 23, where the further component is one of a package substrate, a flexible substrate, or an interposer.

Example 25 provides the IC package according to examples 23 or 24, where the further component is coupled to the IC die via one or more first level interconnects.

Example 26 provides the IC package according to example 25, where the one or more first level interconnects include one or more solder bumps, solder posts, or bond wires.

Example 27 provides a computing device that includes a circuit board; and an IC die coupled to the circuit board, where the IC die includes one or more of the transistor/IC devices according to any one of the preceding examples (e.g., transistor/IC devices according to any one of examples 1-20), and/or the IC die is included in the IC package according to any one of the preceding examples (e.g., the IC package according to any one of examples 23-26).

Example 28 provides the computing device according to example 27, where the computing device is a wearable computing device (e.g., a smart watch) or hand-held computing device (e.g., a mobile phone).

Example 29 provides the computing device according to examples 27 or 28, where the computing device is a server processor.

Example 30 provides the computing device according to examples 27 or 28, where the computing device is a motherboard.

Example 31 provides the computing device according to any one of examples 27-30, where the computing device further includes one or more communication chips and an antenna.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize. These modifications may be made to the disclosure in light of the above detailed description.

## Claims

1. An integrated circuit (IC) device comprising:
a first semiconductor structure;
a second semiconductor structure, the first semiconductor structure and the second semiconductor structure arranged in a stack;
a gate between the first semiconductor structure and the second semiconductor structure; and
a spacer between the first semiconductor structure and the second semiconductor structure, the spacer comprising:
a first layer having a first portion in contact with the first semiconductor structure, a second portion in contact with the second semiconductor structure, and a third portion along the gate, wherein the first layer does not include oxygen; and
a second layer nested within the first layer.

2. The IC device of claim 1, wherein the first portion of the first layer of the spacer is between the second layer of the spacer and the first semiconductor structure, and the second portion of the first layer of the spacer is between the second layer of the spacer and the second semiconductor structure.

3. The IC device of claim 1 or 2, wherein an edge of the first layer of the spacer, an edge of the second layer of the spacer, an edge of the first semiconductor structure, and an edge of the second semiconductor structure are aligned.

4. The IC device of claim 1, wherein the first layer comprises nitrogen.

5. The IC device of claim 4, wherein the first layer comprises titanium.

6. The IC device of claim 4, wherein the first layer comprises silicon.

7. The IC device of any preceding claim, wherein the first layer comprises carbon.

8. The IC device of any preceding claim, wherein the first layer comprises a low-k material.

9. The IC device of any preceding claim, wherein the first layer comprises a first material, the second layer comprises a second material, and a first dielectric constant of the first material is less than a second dielectric constant of the second material.

10. The IC device of any preceding claim, wherein the first layer has a thickness of less than 2 nanometers.

11. The IC device of any preceding claim, wherein the spacer is a first spacer, the IC device further comprises a second spacer between the first semiconductor structure and the second semiconductor structure, and the gate is between the first spacer and the second spacer.

12. The IC device of any preceding claim, wherein the second layer comprises oxygen.

13. The IC device of any preceding claims, further comprising a source or drain region, the spacer between the source or drain region and the gate.

14. The IC device of any preceding claim, wherein the gate comprises a dielectric layer and a conductive layer, and the first layer of the spacer is between the dielectric layer of the gate and the second layer of the spacer.

15. A method comprising:
providing a stack of elongated structures of a first material with regions of a second material between adjacent ones of the elongated structures, each elongated structure in the stack having a first end and a second end;
etching portions of the second material from the first end of the stack and the second end of the stack to form a first plurality of cavities at the first end and a second plurality of cavities at the second end;
depositing a first spacer material in first plurality of cavities and the second plurality of cavities, the first spacer material lining an upper portion, side portion, and lower portion of one of the cavities; and
depositing a second spacer material over the first spacer material, the second spacer material filling the one of the cavities.
